(19) Europäisches Patentamt
European Patent Office
Office européen des brevets

(11) EP 4 043 961 B1

(12) **EUROPÄISCHE PATENTSCHRIFT**

(45) Veröffentlichungstag und Bekanntmachung des Hinweises auf die Patenterteilung:
**16.08.2023 Patentblatt 2023/33**

(21) Anmeldenummer: **21156623.7**

(22) Anmeldetag: **11.02.2021**

(51) Internationale Patentklassifikation (IPC):
***G03F 7/00*** *(2006.01)* ***G03F 7/029*** *(2006.01)*
***G03F 7/031*** *(2006.01)* ***G03F 7/032*** *(2006.01)*
***G03F 7/033*** *(2006.01)* ***G03F 7/105*** *(2006.01)*
***G03F 7/027*** *(2006.01)* ***C08F 2/50*** *(2006.01)*
***G02B 5/18*** *(2006.01)* *G02B 5/32 (2006.01)*

(52) Gemeinsame Patentklassifikation (CPC):
**G03F 7/001; C08F 2/50; G02B 5/1857; G03F 7/027; G03F 7/029; G03F 7/031; G03F 7/032; G03F 7/033; G03F 7/105;** G02B 5/32; G03H 2260/12

(54) **2K-SYSTEM**

2K SYSTEM

SYSTÈME 2K

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.08.2022 Patentblatt 2022/33**

(73) Patentinhaber: **Xetos AG**
**85662 Hohenbrunn (DE)**

(72) Erfinder: **KNOCKE, Frank**
**85560 Ebersberg (DE)**

(74) Vertreter: **Gerauer, Marc Philippé**
**Kraus & Weisert**
**Patentanwälte PartGmbB**
**Thomas-Wimmer-Ring 15**
**80539 München (DE)**

(56) Entgegenhaltungen:
**EP-B1- 3 313 827**
**WO-A1-2011/054793**
**WO-A2-2005/124456**
**US-A1- 2016 320 695**
**US-A1- 2016 362 507**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Processed by Luminess, 75001 PARIS (FR)

## Beschreibung

### Gebiet der Erfindung

Die vorliegende Erfindung bezieht sich auf ein Zweikomponentensystem (Kit-of-parts) und daraus hergestellte Elemente sowie deren Verwendung. Die aus dem Kit-of-parts hergestellten photopolymerisierbaren Zusammensetzungen eignen sich insbesondere als Aufzeichnungsmaterialien für optische Elemente mit Brechungsindexmodulation, insbesondere Hologramme.

Es ist eine Vielzahl von Hologrammen wie Reflexionshologramme, Prägehologramme oder Transmissionshologramme oder Volumenhologramme bekannt.

Ein Volumenhologramm wird beispielsweise dadurch hergestellt, indem zwei Lichtwellen gleicher Wellenlänge, auch Objekt- und Referenzstrahl genannt, zur Interferenz gebracht und ein holographisches Aufzeichnungsmedium, in der Regel ein photographischer Film, mit dem entstehenden Interferenzmuster, das i.d.R. ein Intensitätsmuster ist, belichtet wird. Der holographische Belichtungsprozess und die Vervielfältigung des Hologramms (Replikation) sind technisch komplexe optische Verfahren, die spezielle anwendungstechnische Kenntnisse erfordern. Methoden zur Erzeugung von Hologrammen und die Theorie sind in der Literatur umfassend beschrieben [Howard M. Smith, "Principles of Holography", Wiley (1969)] [Fred Unterseher, et al. "Holography Handbook: Making Holograms the Easy Way", Ross Books (1982)] [Graham Saxby, "Practical Holography", Inst, of Physics Pub. (2004)].

Bekannte Aufzeichungsmaterialien mit unterschiedlichem Eigenschaftsprofil und Anwendungsgebiet sind: Silberhalogenid-Emulsionen, gehärtete Dichromat-Gelatine, ferroelektrische Kristalle, photochrome und dichroide Materialien sowie Photopolymere [Howard M. Smith, "Principles of Holography", Wiley (1969).]. Für Anwendungen mit hohen Stückzahlen sind solche Materialien von Interesse, die problemlos in den Anlagen zur Hologrammherstellung und -Vervielfältigung integriert werden können und die eine einfache holographische Belichtung und Entwicklung ermöglichen. Photopolymere gelten aufgrund ihrer hohen Effizienz, ihrer einfachen Handhabung und ihrer guten Lagerstabilität als besonders bevorzugt. Die bekanntesten Photopolymere stammen von DuPont, z.B. Omnidex HRF 600 [S. M. Schultz, et al. "Volume grating preferential-order focusing waveguide coupler," Opt. Lett., vol. 24, pp. 1708-1710, Dec. 1999.] Omnidex-Materialien gehört zu der Klasse der sich selbstentwickelnden Photopolymerfilme basierend auf radikalischer Polymerisation und Monomerdiffusion (siehe EP 0 324 480 A2).

Omnidex-Photopolymere wurden im Laufe der Jahre weiterentwickelt, primär mit dem Ziel, den Brechungsindexkontrast zu erhöhen und im Film einen hohen Beugungswirkungsgrad zu erzielen (siehe US 4942112 A und DE 69032682 T2). Dennoch werden die anwendungstechnisch relevanten Beugungswirkungsgrade von deutlich über 2/3 durch einen hohen Anteil an thermoplastischem Binder erkauft.

Bei der Filmherstellung muss der Binder für die Beschichtung flüssig sein. Dazu wird ein Lösemittel eingesetzt, dessen Abdampfen nach der Beschichtung zu einer starken Abnahme der Schichtdicke führt. Die aufzutragende Nassschicht ist daher entsprechend dem Lösemittelanteil wesentlich dicker als die resultierende Filmschicht. Der Lösemittelanteil beträgt i.d.R. etwa 80%. Um eine volumenholographisch belichtbare Schicht von 20$\mu$m zu erreichen, muss in diesem Fall eine Nassschicht von 100$\mu$m aufgetragen werden. Die erforderliche hohe Dicke der Nassschicht verhindert oder erschwert die Verwendung von bekannten Druckverfahren, wie Flexo- oder Tiefdruck. Beim Siebdruck kann es bei der Verwendung von schnell trocknenden Lösungsmitteln zu einer Verklebung des Netzes kommen.

Der Film kann zudem erst weiter verarbeitet bzw. aufgewickelt werden, wenn das gesamte Lösemittel abgedampft ist. In der Produktion muss daher eine lange Trocknungsstrecke mit einer gesundheits- und umweltgerechten Absaugung, sowie einer staub- und explosionsgeschützter Umgebung aufgebaut werden. Dieser Aufwand führt dazu, dass die Filmherstellung und die holographische Belichtung i.d.R. an getrennten Orten und Zeiten stattfindet.

Bei den binderhaltigen Materialien ist zudem eine thermische Nachbehandlung ("Tempern") des belichteten und UV-fixierten Photopolymeren nötig, um den maximalen Brechungsindexkontrast zu erzielen (siehe DE 68905610 T2). Das Tempern ist ein zusätzlicher zeitaufwendiger Verarbeitungsschritt, der die Hologrammherstellung neben der aufwendigen Filmherstellung verlangsamt, verkompliziert und verteuert und zudem die Wahl der Trägermaterialien auf nicht temperaturempfindliche einschränkt.

Andere Photopolymer-Materialien für die Volumenholographie wurden von Polaroid (siehe US 5759721 A, Fuji Photo Film (siehe EP 1 510 862 A2), Konica Minolta Medical & Graphic (siehe US 200505891 A1), Dai Nippon Printing (siehe EP 123151 A1), Nippon Paint (siehe EP 0 211 615A2), Nissan Chemical Industries (siehe US 20050068594 A1), Bayer (siehe WO 2010091795 A1), Xetos (siehe WO 2003036389 A1) und InPhase Technologies (siehe US 2002142227 A1) entwickelt. Der Stand der Technik weist Photopolymere aus, die sich durch ihre holographischen Eigenschaften oder ihre Verarbeitung von Omnidex unterscheiden. Der technische Fortschritt wird durch verringerte Sauerstoffempfindlichkeit dokumentiert, reduzierten Materialschrumpf während der Belichtung, angepasste spektrale Empfindlichkeit (Sensitivität), lösemittelfreie Filmherstellung, höheren Beugungswirkungsgrad ohne Tempern und/oder bessere Temperatur- und Lagerstabilität.

EP 3 313 827 B1 betrifft aromatische 4,6-Bis-trichlormethyl-s-triazin-2-yl-Verbindungen der Formel (I). Weitere

Gegenstände der Erfindung sind eine Photopolymer-Formulierung enthaltend eine photopolymerisierbare Komponente und mindestens eine aromatische 4,6-Bis-trichlormethyl-s-triazin-2-yl-Verbindung der Formel (I) und ein Photopolymer, umfassend Matrixpolymere, ein Schreibmonomer, einen Photoinitiator und mindestens eine aromatische 4,6-Bis-trichlormethyl-s-triazin-2-yl-Verbindung der Formel (I), ein holographisches Medium, das das entsprechende erfindungsgemäße Photopolymer enthält, ein Hologramm enthaltend ein erfindungsgemäßes holographisches Medium, ein Verfahren zur Herstellung eines Hologramms mittels gepulster Laserstrahlung sowie die Verwendung eines erfindungsgemäßen holographischen Mediums zur Aufzeichnung von Hologrammen.

Ein neueres und kommerziell erhältliches holographisches Photopolymer ist das von Bayer Materialscience entwickelte "Bayfol HX"-Film. Dieser enthält als Polymermatrix, welche die holographisch belichtbaren Schreibmonomere aufnimmt, keinen thermoplastischen Binder, sondern ein Polyurethan. Das Polyurethan entsteht durch Polyaddition aus einem Polyisocyanat und Polyol Gemisch. Die reaktiven Komponenten werden erst kurz vor der Beschichtung zusammengemischt und härten auf der Trägerfolie aus. Ein hoher Lösemittelanteil wie bei den vorher beschriebenen binderhaltigen Materialien ist zwar nicht vorhanden, aber durch die Aushärtungszeit von bis zu einer Stunde besteht die selbe Problematik, eine genügend lange staubfreie Trocknungs- bzw. Härtungsstrecke in der Beschichtungsanlage zur Verfügung zu stellen.

Wie bei allen kommerziell erhältlichen Photopolymerfilmen kann der Anwender das Trägermaterial nicht frei wählen und selber beschichten, sondern muss den gelieferten Folienaufbau verarbeiten. Neben der Trägerfolie befindet sich noch eine Kaschierfolie auf der lichtempfindlichen Filmschicht, um eine Verklebung und Verschmutzung zu vermeiden. Das Abziehen dieser Folie kann eine statische Aufladung bewirken, die Staubpartikel anzieht. Da der Film zur Belichtung entweder auf Glas oder einem Master auflaminiert werden muss, wo jedes Staubteilchen eine Fehlstelle erzeugt, wird für eine saubere und fehlerlose Verarbeitung eine extrem staubfreie Umgebung benötigt.

Photopolymersysteme, die einen polymeren Binder oder polymere Matrix enthalten, bilden eine im Wesentlichen feste Filmschicht. Im Unterschied dazu sind auch Binder-freie Systeme vorgestellt worden, die bis zur Belichtung im Wesentlichen flüssig sind (siehe z.B. US-Patent 3,993,485 A oder N. Smirnova, Optics in Information Systems, February 2004, S. 9 oder Xetos (siehe WO 2003036389 A1).

Bei den meisten im Wesentlichen festen Monomer-Binder/Matrix-Photopolymeren diffundieren nach der holographischen Laserbelichtung nicht belichtete Schreibmonomere, die sich im Bereich der dunklen Interferenzlinien befanden, in die belichteten polymerisierten Bereiche nach. Dadurch entsteht ein Brechungsindexunterschied dessen räumliche Modulation dem aufzuzeichnenden Interferenzmuster entspricht. Die Diffusion der Schreibmonomere in der festen Matrix benötigt allerdings Zeit. Eine Temperaturerhöhung kann diesen Vorgang beschleunigen. DuPont gibt für das genannte OmniDex®-Material eine Temperzeit von einer Stunde bei 120°C an. Beim Bayfol HX-Material wird in den Patenanmeldungen (EP 2 372 454 A1 S.13 [0127], EP 2 219 073 A1 S.15 [0102]) eine Wartezeit von 5min angegeben bevor das Material mit UV-Licht endgültig komplett gehärtet wird,

Für viele Produktionsverfahren sind aber möglichst geringe Zeiten bzw. ein möglichst hoher Durchsatz und eine einfache, kostengünstige Prozessführung für die Herstellung der Hologramme gefordert, so dass umständliche und zeitintensive Nachbehandlungen oder Wartezeiten von Nachteil sind.

Aus diesem Grund wurden photopolymerisierbare Zusammensetzungen entwickelt, die eine effektive Brechungsindexmodulation schon während der Laserbelichtung ausbilden und sofort mit UV-Licht fixiert werden können, wie dies in der EP 1 779 196 B1 beschrieben wird. Dort wurden verschiedene Triglyceride, wie z.B. Rizinusöl, verwendet.

Die Lagerungsfähigkeit spielt bei den bekannten photopolymerisierbaren Zusammensetzungen aufgrund der Lichtempfindlichkeit und der Anwesenheit von Initiatoren eine entscheidende Rolle, da es wünschenswert ist, immer die gleiche Qualität bereitzustellen.

Ein Nachteil der oben genannten flüssigen photopolymerisierbaren Zusammensetzung EP 1 779 196 B1 ist, dass das als Coinitiator verwendete Boratsalz, SEC-LCA 1460 der Fa. BASF (früher CGI 7460 der Fa. Ciba), nach einiger Zeit gerne auskristallisiert. Es hat einen Schmelzpunkt von 80°C. Durch Erwärmen und Rühren kann das Borat zwar wieder in Lösung gebracht werden, allerdings besteht die Gefahr, dass es dabei zu einer thermisch initiierten Polymerisation kommt oder die Lichtempfindlichkeit wegen thermischer Reaktionen des Farbstoffes abnimmt. Besonders, wenn z.B. als Farbstoff Methylenblau oder zur Steigerung der Lichtempfindlichkeit Zusatzstoffe wie z.B. NPG (N-Phenylglycin) oder zur Erhöhung der Reaktionsgeschwindigkeiten thermisch aktivierbare Initiatoren wie Peroxide (tert-Butylperoxybenzoate) verwendet werden, die empfindlich auf höhere Temperaturen reagieren, chemische Reaktionen eingehen, sich zersetzen, ausbleichen, Trübungen verursachen oder eine radikalische Polymerisation einleiten können.

Die Zugabe von Lösemitteln in höheren Mengen, die das Borat auch über längerer Zeit in Lösung halten würden ist kontraproduktiv, da dies die holographische Qualität der photopolymerisierbaren Zusammensetzung oder die schnelle Verarbeitbarkeit verschlechtern würde.

## Beschreibung der Erfindung

Der vorliegenden Erfindung liegt somit die Aufgabe zugrunde, ein holographisches System bereitzustellen, das

die genannten Nachteile bekannter Aufzeichnungsmaterialien vermeidet und insbesondere eine längere verbesserte Lagerzeit bzw. Verwendbarkeitsdauer und trotzdem eine einfache und sehr schnelle Verarbeitung ermöglicht. Die aus dem Aufzeichnungsmaterial hergestellten holographischen Elemente sollten außerdem eine möglichst hohe Brechungsindexmodulation sowie eine hohe Langzeitstabilität als auch eine thermische und mechanische Stabilität aufweisen und besonders transparent, klar und nicht trüb sein.

Zudem ist zu gewährleisten, dass die aus dem Kit-of-parts hergestellten photopolymerisierbaren Zusammensetzungen eine schichtweise Belichtung ermöglichen, ohne dass die unteren schon gehärteten Schichten von der frisch aufgetragenen Nassschicht angegriffen und deren mechanischen, optischen und holographischen Qualität verschlechtert werden.

Insbesondere soll die Erfindung dem Anwender ermöglichen, eigene Trägermaterialien bzw. Produkte zu beschichten und kurz danach ohne notwendige Wartezeiten holographisch zu belichten.

Die Aufgabe wird erfindungsgemäß gelöst durch ein Kit-of-parts zur Herstellung einer photopolymerisierbaren Zusammensetzung mittels UV/Vis-Bestrahlung, umfassend:

I) ein Farbstoffkonzentrat, umfassend

A) eine erste Mischung A, insbesondere flüssige Mischung A, umfassend

f) mindestens einen Farbstoff und
h) mindestens ein Lösungsmittel
und

II) eine flüssige Zusammensetzung umfassend:

B) eine monomerhaltige flüssige Mischung B, umfassend:

a) mindestens ein Monomer M1, umfassend mindestens eine ethylenisch ungesättigte Gruppe,
c) mindestens einen Co-Photoinitiator,

wobei über 80% aller Bestandteile des Lösungsmittels in dem Kit-of-parts oder in dem Farbstoffkonzentrat einen Dampfdruck von ≤ 2 hPa bei 20°C und einen Siedepunkt von ≥ 100°C bei Standarddruck aufweisen, und wobei in dem Lösungsmittel ein unter Standarddruck flüssiges Polymer enthalten ist und wobei nach der Anmischung der photopolymerisierbaren Zusammensetzung diese sofort verarbeitbar und belichtbar ist.

Bevorzugt ist ebenfalls ein Kit-of-parts zur Herstellung einer photopolymerisierbaren Zusammensetzung mittels UV/Vis-Bestrahlung, wobei die erste Mischung A weiterhin umfasst:

g) mindestens einen Photoinitiator und
wobei der Photoinitiator unter Bestrahlung mit einer Wellenlänge zwischen 100 nm und 480 nm Radikale bilden kann.

Vorzugsweise weisen über 90% und besonders bevorzugt über 98% aller Bestandteile des Lösungsmittels in dem erfindungsgemäßen Kit-of-parts oder in dem Farbstoffkonzentrat einen Dampfdruck von ≤ 2 hPa, bevorzugt ≤ 1,3 hPa und besonders bevorzugt ≤ 0,2 hPa bei 20°C auf.

Zudem weisen über 80%, bevorzugt über 90% und besonders bevorzugt 95% der Lösungsmittelbestandteile einen Siedepunkt von ≥ 100°C bei Standarddruck auf. Die prozentualen Anteile ergeben sich aus dem Gewichtsverhältnis der Bestandteile zum Gesamtgewicht des Lösungsmittels.

Erfindungsgemäß ist in dem Lösungsmittel ein unter Standarddruck flüssiges Polymer enthalten. Dabei stammt das Polymer vorzugsweise aus der Gruppe, bestehend aus Polyethylenglykolen (PEGs), Polycaprolactonen, Acrylat-Block-Copoylmeren (EFKA) und Poly(Bisphenol-A-co-epichlorhydrinen) (EPI).

Die Bereitstellung der erfindungsgemäßen Kit-of-parts ermöglicht es, dass nach der Anmischung der photopolymerisierbaren Zusammensetzung diese sofort verarbeitbar und belichtbar ist.

Vorzugsweise ist die die monomerhaltige flüssige Mischung B bei einem Standarddruck im Bereich von 15°C bis 120°C flüssig.

Für das Kit-of-parts erweist es sich als vorteilhaft ein Farbstoffkonzentrat A (auch I) genannt) mit einem Lösungsmittel, insbesondere eines mit einem Anteil von über 50 Gew.-%, bevorzugt über 65 Gew.-%, besonders bevorzugt über 80 Gew.-% hochmolekularen, nicht flüchtigen Komponenten, einschließlich der Photoinitiatoren, zu verwenden. Dieses wird der flüssigen Zusammensetzung II) (auch II) genannt) zugegeben, um eine photopolymerisierbare Zusammensetzung (auch Photopolymer genannt) zu bekommen, die nach dem Durchmischen sofort aufgetragen und belichtet

werden kann. Zudem kommt es vorteilhafterweise zu keinen Wartezeiten und zeitlichen Änderungen der Materialeigenschaften durch Abdampfen und Konzentrationsänderungen der Lösemittelbestandteile, so dass auch keine gesundheits- und umweltschädliche Dämpfe entstehen können.

Durch die getrennte Aufbewahrung von dem Farbstoffkonzentrat A als I) und der flüssigen Zusammensetzung B als II) verbessert sich die Haltbarkeit und die Lagerung kann vereinfacht werden, da die Komponenten A) und B) weniger Licht- und wärmeempfindlich als die photopolymersierbaren Zusammensetzungen sind.

Insbesondere kann die flüssige Zusammensetzung II) ohne Probleme längere Zeit erwärmt und gerührt werden, um z.B. ungelöste oder auskristallisierte Bestandteile wie das Boratsalz, wieder in Lösung zu bringen.

Vorzugsweise ist die flüssige Zusammensetzung II) überhaupt nicht lichtempfindlich und kann problemlos ohne Vorsichtsmaßnahmen, wie das Einhalten einer bestimmten Umgebungsbeleuchtung, visuell begutachtet, erwärmt und gerührt werden. Dies erleichtert die Qualitätskontrolle und das Entdecken ungelöster oder auskristallisierter Bestandteile, sowie die Verarbeitung.

Vorteilhafterweise wird über die Farbe eingestellt, für welches Licht das Kit-of-parts empfindlich ist. Um die Energie des Lichtes zu absorbieren, wird in der Regel der komplementäre Farbton von der Belichtungswellenlänge gewählt. Für ein grünes Licht wird z.B. ein Magenta-, für Rot ein Blau- und für Blau ein Gelbton verwendet. Für die Belichtung mit verschiedenen Wellenlängen sind auch Kombinationen möglich.

Vorzugsweise besteht das Kit-of-part aus der flüssige Zusammensetzung II), welche ganz besonders bevorzugt eine klare, farblose und flüssige monomerhaltige Mischung ist, und dem Farbstoffkonzentrat I). Das Farbstoffkonzentrat wird vorzugsweise in Mengen von 0,5-50 Gew.-%, bevorzugt von 1-10 Gew.-% und besonders bevorzugt von 1-5 Gew.-%, bezogen auf die Gesamtmenge des Kit-of-parts, insbesondere der flüssige Zusammensetzung II), zugegeben und durch Rühren, Schütteln oder Verwirbeln vermischt.

Die daraus resultierende photopolymerisierbare Zusammensetzung kann sofort nach dem Auftragen auf ein Substrat belichtet werden. Der Nassauftrag der Zusammensetzung auf das Trägermaterial kann durch Rakeln, Doctor Blade oder Schlitzdüsen (Slot-Dye Coating) erfolgen. Für dünne Schichten kleiner 20 $\mu$m können auch bekannte Druckverfahren, wie Sieb-, Tief-, Gravur-, Tampon- oder Flexodruck verwendet werden. Bevorzugt wird das Material mit einer transparenten und klaren Folie direkt auf die zu kopierende Vorlage (Master) laminiert. Die Schichtdicke wird entweder durch den Anpressdruck und der Laminiergeschwindigkeit oder über die Schlitzbreite eingestellt. Bei der Beschichtung von dicken und starren Trägern wie z.B. Glasplatten kann ein Spin Coating Verfahren verwendet werden. Auch das Auftragen mit einem Tintenstrahldruckverfahren oder mit einer CNC gesteuerten Dosiervorrichtungen ist möglich. Das direkte Einspritzen in Hohlräumen ist ebenfalls möglich.

Insbesondere eignet sich das flüssige Material auch für den Auftrag auf gekrümmten Oberflächen. Es kann auch zwischen zwei zueinander passenden Körpern eingepresst und gleichzeitig als Kit oder Kleber verwendet werden.

Die Vermischung der Kit-of-parts-Bestandteile kann in der Beschichtungsanlage stattfinden. Zur Vermischung können alle den Fachmann bekannten Mischungstechniken und -verfahren, wie z.B. Rührkessel, Magnetrührer, Rührstäbe, Speedmixer und sowie sowohl als auch dynamische und statische Mischer eingesetzt werden.

Nach der Vermischung können die zusätzlichen üblichen und den Fachmann bekannten Verfahren wie Filtration und Entgasung eingesetzt werden Wenn es technisch vorteilhaft ist, kann z.B. auch eine 1:1 oder 1:2 Variante angeboten werden. In diesem Fall wird das Farbstoffkonzentrat A mit einer Verdünnungsmischung auf das gewünschte Verhältnis gestreckt. Die Verdünnungsmischung enthält die aus der flüssigen Zusammensetzung II) bekannten Komponenten und Monomere ohne die kritischen Bestandteile, die wie das Boratsalz nach längerer Lagerung durch Erwärmen wieder in Lösung gebracht werden müssen. In der monomerhaltigen flüssigen Mischung B muss dann stattdessen das dem Verhältnis entsprechende mehrfache der sonst üblichen Menge von den kritischen Bestandteilen bzw. den Boratsalzen enthalten sein.

Nach der Belichtung ist die Schicht fest. Vorzugsweise wird bei den aus dem Kit-of-parts hergestellten photopolymerisierbaren Zusammensetzungen nach dem Belichten keine thermische oder chemische Nachbehandlung benötigt.

Durch den Verzicht von Stoffen, die nach der Zugabe oder dem Beschichten erst abdampfen oder chemisch reagieren müssen, ist zu einem sichergestellt, dass zwischen Anmischen, Auftragen und Belichten ein Zeitraum von weniger als 30 min, bevorzugt weniger als 10 min, besonders bevorzugt weniger als 2 min genutzt werden kann. Zum anderen wird dadurch ermöglicht, dass die Schicht nicht offen aufgetragen werden muss, sondern in Zwischenräumen eingebracht oder mit einer abdeckenden Folie auf laminiert werden kann. Dieser Umstand vereinfacht das Verfahren für die Herstellung von Hologrammen wesentlich und ermöglicht sehr kompakte Maschinen.

Durch die kurze Verarbeitungszeit, den kurzen Transportwegen und die Möglichkeit nach dem Auftragen sofort und schnell belichten zu können, verringern sich auch die Anforderungen an das Umgebungslicht. Dies vereinfacht den Aufbau und die Bedienung der Maschine, da sie nicht aufwendig vor Lichteinfall geschützt werden und nicht unbedingt in einem extra abgedunkelten Raum stehen muss.

Der Anwender hat außerdem die freie Wahl, welche Trägermaterialien und Schichtaufbauten er verwenden möchte, da die Beschichtung in der Belichtungsanlage erfolgt. Nach dem Auftrag kann sofort belichtet werden. Mehrschichtige Belichtungen sind ebenfalls kein Problem, da nach der Härtung nach den selben Prinzip eine neue Schicht aufgetragen und holographisch belichtet werden kann. Dies kann z.B. dazu genutzt werden, um echtfarbige Hologramme aus drei Schichten für die Grundfarben Rot, Grün und Blau aufzubauen.

Die photopolymerisierbare Zusammensetzung aus dem Kit-of-parts ist besonders für die Anfertigung von Kontaktkopien geeignet. Dadurch, dass die flüssige photopolymerisierbare Zusammensetzung aus dem Kit-of-parts direkt auf das Master aufgedruckt wird, entfällt das Indexmatching. Darunter wird das Auftragen einer Flüssigkeit zwischen Master und Hologrammfilm mit ungefähr dem gleichen Brechungsindex der beiden Schichten verstanden. Das Indexmatching verhindert beim normalen Kontaktkopierverfahren das Auftreten von störenden Interferenzerscheinungen (Newtonringe). Diese entstehen durch Reflexionen, die besonders an den Stellen auftreten, wo sich die beiden Schichten z.B. wegen eines Staubeinschlusses oder einer kleinen Unebenheit nicht direkt berühren und es zu Blasen bzw.Lufteinschlüssen kommt. Zudem verbessert der Ausgleich von Kratzern und anderen Unebenheiten vom Trägermaterial und Master die optische Qualität der Kopie. Kleine Staubteilchen mit einer geringeren Abmessung als die Schichtdicke werden in der Flüssigkeit eingebettet und erzeugen keine deutlichen Druck- und Fehlstellen wie bei den Filmmaterialien. Dies verringert den Ausschuss und die Reinraumansprüche an die Produktionsumgebung wesentlich.

Vorteilhaft kann die flüssige photopolymerisierbare Zusammensetzung aus dem Kit-of-parts somit auch als Indexmatch-Material für die Belichtung von holographischen Filmmaterialien eingesetzt werden. Dadurch, dass es beim Belichten aushärtet entfällt die Reinigung oder das Abdampfen. Zudem wird die holographische Aufzeichnung durch die Kombination der beiden holographischen Aufzeichnungsmaterialien unterstützt und verstärkt, da in beiden Schichten ein Hologramm entsteht. Durch die freie Wahl des verwendeten Farbstoffkonzentrates kann der Anwender entscheiden, welcher Wellenlängen- bzw. Farbbereich in der Kombination gepusht wird.

Weil sich die photopolymerisierbare Zusammensetzung aus dem Kit-of-parts jeder Oberfläche anpasst, können im Gegensatz zu den Filmmaterialien neben der Hologrammbelichtung gleichzeitig auch Oberflächenstrukturen abgeformt und komplex geformte Oberflächen verwendet werden. Die Oberflächenstrukturen können insbesondere Prägehologramme oder Fresnelstrukturen sein. Dadurch ist es möglich, in einem einzelnen Verarbeitungsschritt sowohl die Oberflächenstruktur als auch die volumenholographische oder optische Information des Masters physikalisch und holographisch zu kopieren.

Auf dieser Weise lassen sich auch optische Elemente wie Prismen oder Linsen mit integrierten Hologrammstrukturen herstellen.

## Farbstoff

Der Farbstoff dient als Sensibilierungsmittel für den Co-Photoinitiator. Dafür eignet sich z.B. Methylenblau und die in den US-Patenten 3 554 753 A, 3 563 750 A, 3 563 751 A, 3 647 467 A, 3 652 275 A, 4 162 162 A, 4 268 667 A, 4 454 218 A, 4 535 052 A und 4 565 769 A, offenbarten Sensibilisierungsmittel, sowie die in der Anmeldung WO 2012062655 A2 genannten Farbstoffe und Co-Photoinitiatoren, auf die hierin ausdrücklich Bezug genommen wird. Zu den besonders bevorzugten Sensibilisierungsmitteln gehören die folgenden: DBC, d.h., 2,5-Bis[(4-diethylamino-2-methylphenyl)methylen]cyclopentanon; DEAW, d.h., 2,5-Bis[(4-diethylaminophenyl)methylen]cyclopentanon; Dimethoxy-JDI, d.h., 2,3-Dihydro-5,6-dimethoxy-2-[(2,3,6,7-tetrahydro-1H,5H-benzo[i,j]chinolizin-9-yl)methylen]-1H-inden-1-on; und Safranin O, d.h., 3,7-Diamino-2,8-dimethyl-5-phenyl-phenaziniumchlorid.

Vorzugsweise ist der Farbstoff in dem erfindungsgemäßen Kit-of-parts ein Fluoreszenzfarbstoff, der beispielsweise aus einem kationischen Farbstoff und einem Anion bestehen kann. Dabei kann der kationische Farbstoff durch die Formel $F^+$ wiedergegeben werden.

Daher versteht man unter einem kationischen Farbstoff der Formel $F^+$ bevorzugt solche der folgenden Formeln:

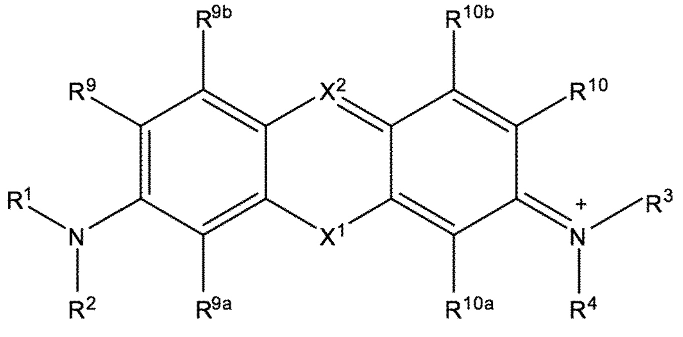

(I),

worin

$X^1$ für O, S, N-$R^6$ oder $CR^{6a}R^{6b}$ steht,

$X^2$ für N oder C-$R^5$ steht,

$R^5$ für Wasserstoff, Cyano, $C_1$- bis $C_4$-Alkyl, $C_4$- bis $C_{7-}$Cycloalkyl, einen ggf. durch $C_1$- bis $C_4$-Alkoxycarbonyl oder $NR^7R^8$ substituierten $C_6$- bis $C_{10}$-Aryl , einen heterocyclischen Rest oder für $C_6$- bis $C_{10}$-Aryl substituiert mit einer Carboxylgruppe steht,

$R^6$ für Wasserstoff, $C_1$- bis $C_{16}$-Alkyl, $C_4$- bis $C_{7-}$Cycloalkyl, $C_7$- bis $C_{16}$-Aralkyl, $C_6$- bis $C_{10}$-Aryl oder einen heterocyclischen Rest steht,

$R^{6a}$ und $R^{6b}$ unabhängig voneinander für Methyl, Ethyl oder gemeinsam für eine $-CH_2-CH_2-CH_2-$ oder $-CH_2-CH_2-CH_2-CH_2-$Brücke oder für $C_6$- bis $C_{10}$-Aryl substituiert mit einer Carboxylgruppe stehen,

$R^1$ bis $R^4$, $R^7$ und $R^8$ unabhängig voneinander für Wasserstoff, $C_1$- bis $C_{16}$-Alkyl, $C_4$- bis $C_{7-}$Cycloalkyl, $C_7$- bis $C_{16}$-Aralkyl, $C_6$- bis $C_{10}$-Aryl oder einen heterocyclischen Rest stehen oder

$NR^1R^2$, $NR^7R^4$ und $NR^7R^8$ unabhängig voneinander für einen fünf- oder sechsgliedrigen, über N angebundenen gesättigten Ring stehen, der zusätzlich ein N oder O enthalten kann und/oder durch nichtionische Reste substituiert sein kann, oder

$R^1$ bis $R^4$, $R^7$ und $R^8$ unabhängig voneinander mit einem zum N-Atom benachbarten C-Atom des Benzolrings eine zwei- oder dreigliedrige Brücke bilden, die ein O oder N enthalten kann und/oder durch nichtionische Reste substituiert sein kann,

$R^9$, $R^{9a}$, $R^{9b}$, $R^{10}$, $R^{10a}$ und $R^{10b}$ unabhängig voneinander für Wasserstoff, Halogen oder $C_1$ bis $C_4$-Alkyl stehen,

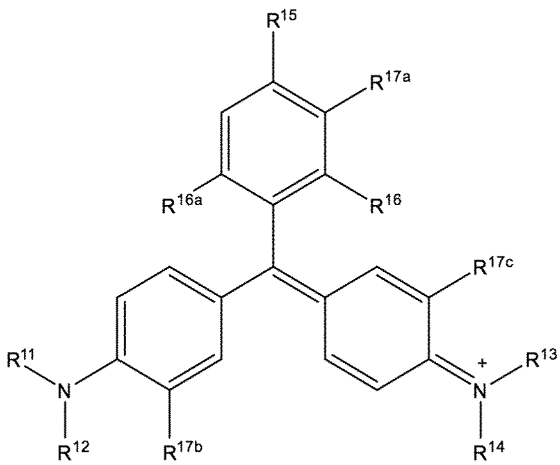

(II),

worin

$R^{15}$ für Wasserstoff, Halogen, $C_1$- bis $C_4$-Alkyl, $C_1$- bis $C_4$-Alkoxy oder $NR^{18}R^{19}$ steht,

$R^{11}$ bis $R^{14}$, $R^{18}$ und $R^{19}$ unabhängig voneinander für Wasserstoff, $C_1$ bis $C_{16}$-Alkyl, $C_4$- bis $C_{7-}$Cycloalkyl, $C_7$- bis $C_{16}$-Aralkyl, $C_6$- bis $C_{10}$-Aryl oder einen heterocyclischen Rest stehen oder

$NR^{11}R^{12}$, $NR^{13}R^{14}$ und $NR^{18}R^{19}$ unabhängig voneinander für einen fünf- oder sechsgliedrigen, über N angebundenen gesättigten Ring stehen, der zusätzlich ein N oder O enthalten kann und/oder durch nichtionische Reste substituiert sein kann, oder

$R^{12}$; $R^{17b}$, $R^{13}$; $R^{17c}$ und $R^{18}$; $R^{17a}$ unabhängig voneinander eine zwei- oder dreigliedrige Brücke bilden, die ein O oder N enthalten kann und/oder durch nichtionische Reste substituiert sein kann,

$R^{16}$ für Wasserstoff, Chlor, Methyl, Methoxycarbonyl oder Ethoxycarbonyl steht,

$R^{16a}$ für Wasserstoff, Chlor oder Methyl steht,

$R^{17a}$, $R^{17b}$ und $R^{17c}$ unabhängig voneinander für Wasserstoff, Chlor, Methyl oder Methoxy stehen.

Nichtionische Reste sind $C_1$- bis $C_4$-Alkyl, $C_1$- bis $C_4$-Alkoxy, Halogen, Cyano, Nitro, $C_1$- bis $C_4$-Alkoxycarbonyl, $C_1$- bis $C_4$-Alkylthio, $C_1$- bis $C_4$-Alkanoylamino, Benzoylamino, Mono-oder Di-$C_1$ - bis $C_4$-Alkylamino.

Alkyl-, Alkoxy-, Cycloalkyl-, Aryl- und heterocyclischen Reste können gegebenenfalls weitere Reste wie Alkyl, Halogen, Nitro, Cyano, CO-$NH_2$, Alkoxy, Trialkylsilyl, Trialkylsiloxy oder Phenyl tragen, die Alkyl- und Alkoxyreste können geradkettig oder verzweigt sein, die Alkylreste können teil- oder perhalogeniert sein, die Alkyl- und Alkoxyreste können ethoxyliert oder propoxyliert oder silyliert sein, benachbarte Alkyl und/ oder Alkoxyreste an Aryl- oder heterocyclischen Resten können gemeinsam eine drei- oder viergliedrige Brücke ausbilden und die heterocyclischen Reste können benzanneliert und/oder quaterniert sein.

Unter Halogen sind Fluor, Chlor, Brom oder lod zu verstehen, vorzugsweise Fluor, Chlor oder Brom.

Beispiele für substituierte Alkylreste sind Trifluormethyl, Chlorethyl, Cyanmethyl, Cyanoethyl, Methoxyethyl, Beispiele für verzweigte Alkylreste sind Isopropyl, tert.-Butyl, 2-Butyl, Neopentyl. Beispiele für Alkoxyreste sind Methoxy, Ethoxy, Methoxyethoxy.

Bevorzugte gegebenenfalls substituierte $C_1$- bis $C_4$-Alkylreste sind Methyl, Ethyl, n-Propyl, Isopropyl, n-Butyl, 2-Butyl, iso-Butyl, tert.-Butyl, perfluoriertes Methyl, perfluororiertes Ethyl, 2,2-Trifluorethyl, 3,3,3 -Trifluorethyl, Perfluorbutyl, Cyanethyl, Methoxyethyl, Chlorethyl.

Als bevorzugtes Aralkyl kommt beispielsweise Benzyl, Phenethyl oder Phenylpropyl in Frage.

Beispiele für $C_6$- bis $C_{10}$-Aryl sind Phenyl und Naphthyl. Beispiele für substituierte Arylreste sind Tolyl, Chlorphenyl, Dichlorphenyl, Methoxyphenyl, Nitrophenyl, Cyanophenyl, Dimethylaminophenyl, Diethylaminophenyl.

Beispiele für Hetarylreste, insbesondere für fünf- oder sechsgliedrige heterocyclische Reste, sind Indolyl, Pyridyl, Chinolyl, Benzthiazolyl. Beispiele für substituierte heterocyclische Reste sind 1,2-Dimethylindol-3-yl, 1-Methyl-2-phenylindol-3-yl.

Anionen für die kationischen Farbstoffe der Formel $F^+$ können beispielsweise Anionen von den Halogenen, Sulfate, Carbonate oder Nitrate sein.

Besonders geeignete kationische Farbstoffe sind Malachit Grün, Methylenblau, Safranin O, Rhodamine der Formel III

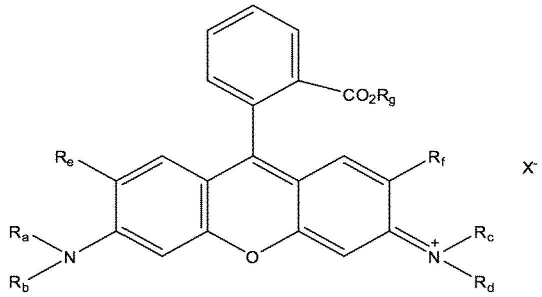

(III)

worin $R_a$, $R_b$, $R_c$, $R_d$, $R_e$, $R_f$ und $R_g$ jeweils H oder eine Alkylgruppe, und X- steht für Chloridion, Trifluoromethansulfonat, Naphthalindisulfonat, para-Toluolsulfonat, Hexafluorophosphat, Perchlorat, meta-Nitrobenzolsulfonat oder meta-Aminobenzolsulfonat, z. B. Rhodamin B, Rhodamin 6 G oder Violamin R, ausserdem Sulforhodamin B oder Sulforhodamin G, wie nachstehend aufgeführt.

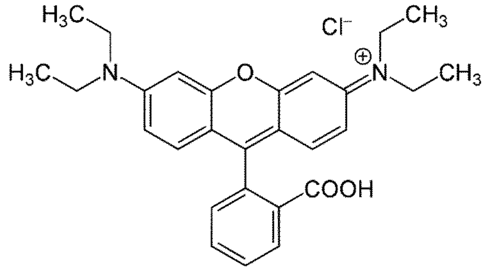

Rhodamine B

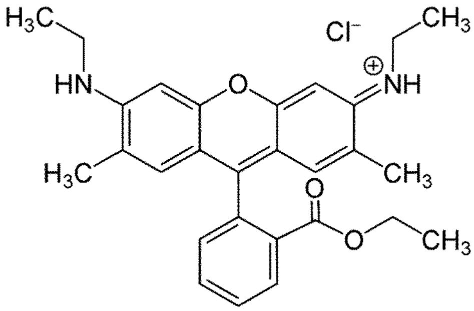

Rhodamine 6G

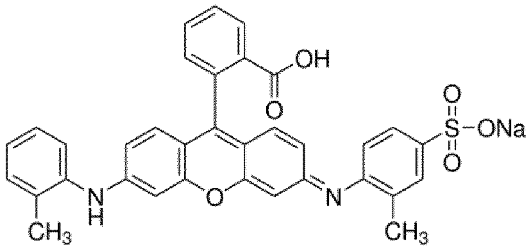

Violamin R

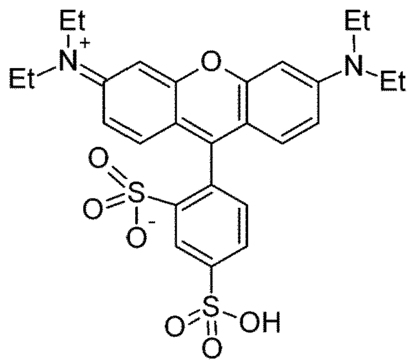

Sulforhodamin B

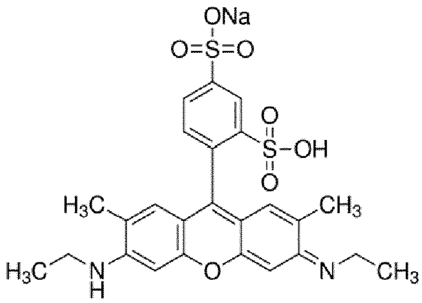

Sulforhodamin G

Andere geeignete Farbstoffe sind Fluorone, wie sie z. B. von Neckers et al. in J. Polym. Sci., Part A, Poly. Chem, 1995, 33, 1691-1703 beschrieben sind. Besonders interessant ist

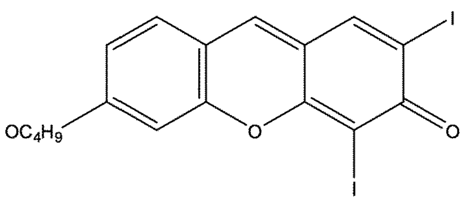

Beispiele für weitere geeignete Farbstoffe sind Cyanine der Formel IV

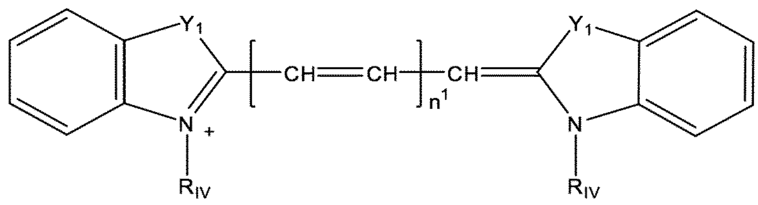

(IV)

worin Riv = Alkyl; $n^1$ = 0, 1, 2, 3 oder 4 und $Y_1$ = CH=CH, N-$CH_3$, $C(CH_3)_2$, O, S oder Se bedeutet. Bevorzugt sind Cyanine, worin $Y_1$ in Formel IV $C(CH_3)_2$ oder S ist.

Vorzugsweise ist der Farbstoff in dem erfindungsgemäßen Kit-of-parts ausgewählt ist aus der Gruppe, bestehend aus Acriflavinen, Diaminoacridinen, Rhodamin B, Safranin-O, Diethylsafranin und Methylenblau.

**Lösungsmittel für den Farbstoff**

Ethanol, Propanol, iso-Propanol, Butanol, iso-Butanol, tert.-Butanol, Pentanol, iso-Pentanol, tert.-Pentanol, Hexanole, Heptanole, Glykole, Diglykol, Triglykol.

Wasser, Methanol, Ethanol, Propanol, Butanol, Ketone, Aceton, Methylethylketon, Ether, Tetrahydrofuran, 1,4-Dioxan, Trioxan,

Triethanolamin (TEA), Rizinusöl, Castor oil glycidylether (Ricinusöl-glycidylether), Octansäure, tert-Butylperoxybenzoat, 2-Dimethylaminoethanol, Anisol, Poly(ethylenglykol)-block-poly(propylenglykol)-block-poly(ethylenglykol), Benzylalkohol, Tetrachlorethylen, Dipropylenglykoldimethylether, Dichlormethan, Essigsäureanhydrid, Propylencarbonat, Essigsäure-n-butylester, Cyclohexan, Cyclopentanone, Ethylenglykol, Polyethylenglykole, Toluol, Eukalyptusöl, Glykolsäurebutylester (Polysolvan-O), N-Methyl-2-pyrrolidon (NMP), Propylenglykolmonomethyletheracetat (PGMEA), Poly(Bisphenol-A-co-epichlorhydrin), Trimethylolpropanethoxytriacrylat (TMPEOTA), Trimethyolpropantriacrylat (TMPTA), Tripropylenglykoldiacrylat (TrPGDA), N,N-Dimethylacrylamid.

Bevorzugt, Dimethylsulfoxid (DMSO), N,N'-Dimethylpropylenharnstoff, N-Hydroxyethylacrylamid (HEAA), Benzaldehyd, Polycaprolactone (PolyCLO, Capromer PT-05), Polycaprolactontriol, Polyethylenglykol (PEG-200), Acryl Block Copolymer (Efka PX 4701).

Als besonders vorteilhaft erwies sich, dass UV-Photoinitiatoren, die sowieso in der photopolymerisierenden Zusammensetzung benötigt werden, überraschenderweise ebenfalls als gute Lösungsmittel für die Farbstoffe verwendet werden können.

Sie sind weiter unten beschrieben, bevorzugt werden die flüssigen Photoinitiatoren Omnirad 1173, Omnirad MBF, Omnirad 1000 und Omnirad TPO-L verwendet. Aber auch die Zugabe von bei Raumtemperatur pulverförmigen UV-Initiatoren zu dem Lösungsmittelgemisch kann die Löslichkeit der Farbstoffe erhöhen.

Vorzugsweise ist in dem Lösungsmittel in unter Standarddruck flüssiges Polymer enthalten. Dabei kann vorteilhafterweise das unter Standarddruck flüssige Polymer ausgewählt sein aus der Gruppe, bestehend aus Polyethylenglykolen (PEGs), Polycaprolactonen, Acrylat-Block-Copoylmeren (EFKA) und Poly(Bisphenol-A-co-epichlorhydrinen) (EPI).

**Photoinitiator**

Vorzugsweise kann der Photoinitiator im Farbstoffkonzentrat im erfindungsgemä-βen Kit-of-parts, unter Bestrahlung mit einer Wellenlänge zwischen 100 nm und 480 nm, bevorzugt zwischen 150nm und 460nm und besonders bevorzugt zwischen 200nm und 380 nm Radikale bilden.

Das erfindungsgemäße Kit-of-parts umfasst eine erste Mischung A, vorzugsweise eine erste flüssige Mischung A, umfassend mindestens einen Photoinitiator, der vorzugsweise die Polymerisation des oder der Monomeren M1 bzw. M2 bei der Einwirkung (aktinischer) Strahlung aktiviert. Dabei handelt es sich vorzugsweise um einen radikalbildenden Polymerisationsinitiator.

Radikalbildende Polymerisationsintitiatoren sind bekannt, vgl. z.B. Timpe, H.J. und S. Neuenfeld, "Dyes in photoinitiator systems", Kontakte (1990), Seiten 28-35 und Jakubiak, J. und J.F. Rabek, "Photoinitiators for visible light polymisation", Polimery (Warschau) (1999), 44, Seiten 447-461.

Zu den geeigneten radikalbildenden Polymerisationsinitiatoren, die durch UV-Strahlung aktivierbar und im allgemeinen bei Temperaturen bis zu 185°C inaktiv sind, gehören die substituierten oder unsubstituierten mehrkernigen Chinone; dabei handelt es sich um Verbindungen mit zwei intracyclischen Kohlenstoff-Atomen in einem konjugierten carbocyclischen Ringsystem, z.B. 9,10-Anthrachinon, 1-Chloranthrachinon, 2-Chloranthrachinon, 2-Methylanthrachinon, 2-Ethylanthrachinon, 2-tert-Butylanthrachinon, Octamethylanthrachinon, 1,4-Naphthochinon, 9,10-Phenanthrenchinon, 1,2-Benzanthrachinon, 2,3-Benzanthrachinon, 2-Methyl-1,4-naphthochinon, 2,3-Dichlornaphthochinon, 1,4-Dimethylanthrachinon, 2,3-Dimethylanthrachinon, 2-Phenylanthrachinon, 2,3-Diphenylanthrachinon, Natrium-Salz von Anthrachinon-α-sulfonsäure, 3-Chlor-2-methylanthrachinon, Retenchinon, 7,8,9,10-Tetrahydronaphthacenchinon und 1,2,3,4-Tetrahyd-robenz[a]anthracen-7,12-dion. Weitere Photoinitiatoren, die ebenfalls brauchbar sind, wenn auch manche bei so niedrigen Temperaturen wie 85°C thermisch aktiv sind, sind in US-Patent 2 760 663 A beschrieben, und zu ihnen zählen vicinale Ketaldonylalkohole wie etwa Benzoin, Pivaloin, Acyloinether, z.B. Benzoinmethyl- und -ethylether, α-Kohlenvwasserstoff-substituierte aromatische Acyloine, darunter α-Methylbenzoin, α-Allylbenzoin und α-Phenylbenzoin.

Als Photoinitiator verwendbar sind photoreduzierbare Farbstoffe und Reduktionsmittel wie etwa die in den US-Patenten 2 850 445 A, 2 875 047 A, 3 097 096 A, 3 097 097 A, 3 145 104 A und 3 579 339 A offenbarten, sowie Farbstoffe aus der Klasse der Phenazine, Oxazine und Chinone; Michlers Keton, Benzophenon, 2,4,5-Triphenylimidazolyl-Dimere mit Wasserstoff-Donoren und deren Mischungen, wie beschrieben in den US-Patenten 3 427 161 A, 3 479 185 A, 3 549 367 A, 4 311 783 A, 4 622 286 A und 3 784 557 A. Eine brauchbare Diskussion der farbstoffsensibilisierten Photopolymerisation findet sich in "Dye Sensitized Photopolymerization" von D.F: Eaton in Adv. in Photochemistry, Bd. 13, D.H. Volman, G.S. Hammond und K. Gollnick, Hrsg., Wiley-Interscience, New York, 1986, S. 427-487. In gleicher Weise sind auch die Cyclohexadienon-Verbindungen von US-Patent Nr. 4 341 860 als Initiatoren brauchbar. Zu den geeigneten Photoinitiatoren gehören CDM-HABI, d.h., 2-(o-Chlorphenyl)-4,5-bis(m-methoxyphenyl)-imidazol-Dimer; o-Cl-HABI, d.h., 2,2'-Bis(o-chlorphenyl)-4,4',5,5'-tetraphenyl-1,1'-biimidazol; und TCTM-HABI, d.h., 2,5-Bis(o-chlorphenyl)-4-(3,4-dimethoxyphenyl)-1H-imidazol-Dimer, die jeweils typischerweise mit einem Wasserstoff-Donor verwendet werden, z.B. 2-Mercaptobenzoxazol.

Besonders bevorzugte UV-Photoinitiatoren sind IRGACURE® OXE-01 (1,2-Octandion-1-[4-(phenylthio)-phenyl]-2-(O-benzoyloxim) und IRGACURE® OXE-02 (1-[9-Ethyl-6-(2-methylbenzoyl)-9H-carbazol-3-yl]ethanon-O-acetyloxim von der der BASF AG, sowie OMNIRAD-MBF (Methylbenzoylformiat), OMNIRAD-TPO (2,4,6-Trimethylbenzoyldiphenyl-phosphinoxid), OMNIRAD-TPO-L (Ethyl-(2,4,6-trimethylbenzoyl)-phenylphosphinat), OMNIRAD-1173 (2-Hydroxy-2-methyl-1-phenylpropanon), OMNIRAD 1000 (Mischung aus 2-Hydroxy-2-methyl-1-phenylpropanon (80%) und 1- Hydroxycyclohexyl-phenylketon (20%)), OMNIRAD 184 (1-Hydroxycyclohexyl-phenylketon), OMNIRAD 819 (Bis(2,4,6-trimethylbenzoyl)phenylphosphinoxid), OMNIRAD 2022 (Mischung aus 2-Hydroxy-2-methyl-1-phenylpropanon, Bis(2,4,6-trimethylbenzoyl)phenylphosphinoxid und Ethyl(2,4,6-trimethylbenzoyl)-phenylphosphinat) und OMNICAT 440 (4,4'-Dimethyl-diphenyl-iodonium-hexafluorphosphat), die von IGM Resins erhältlich sind und bevorzugt in einer Menge von 0,1 bis 10 Gew.-% eingesetzt werden.

| | | | |
|---|---|---|---|
| 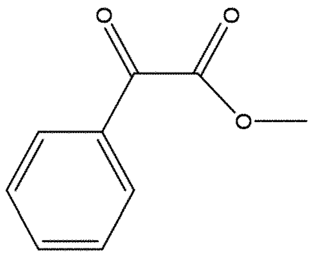 | OMNIRAD MBF | 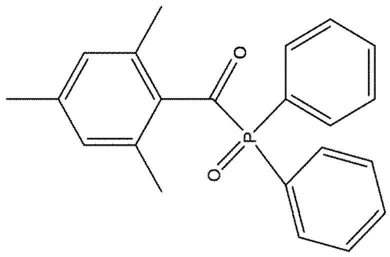 | OMNIRAD TPO |
| | | 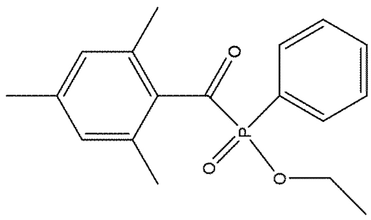 | OMNIRAD TPO-L |
| 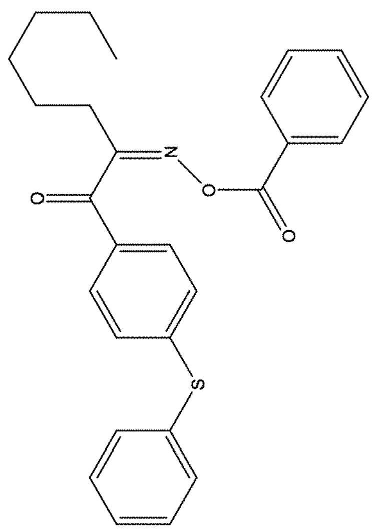 | IRCACUREO OXE-01 | 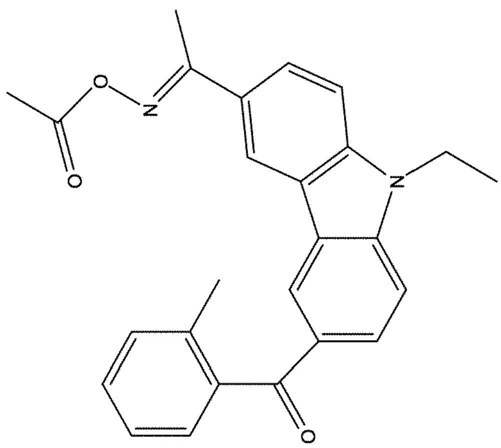 | IRGACURE® OXE-02 |

(fortgesetzt)

| | | |
|---|---|---|
| 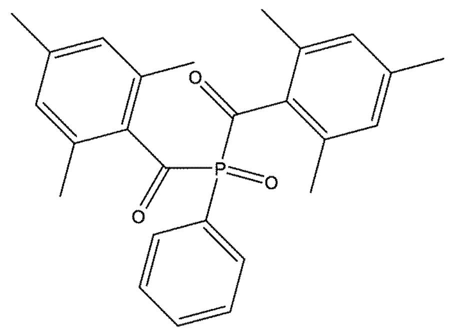 | 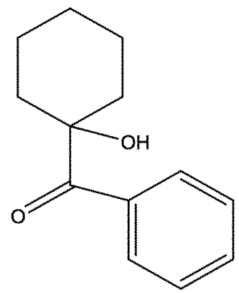 | 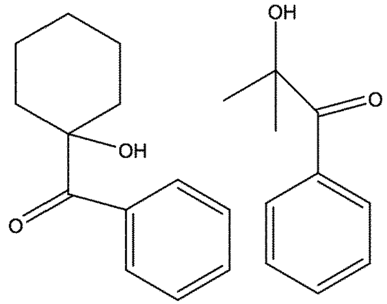 |
| OMNIRAD 819 | OMNIRAD 184 | OMNIRAD 1000 |
| 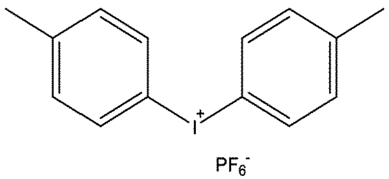 | 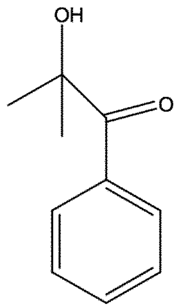 | |
| **OMNICAT 440** | **OMNIRAD 1173** | |

(fortgesetzt)

| | |
|---|---|
| OMNIRAD 2022 | 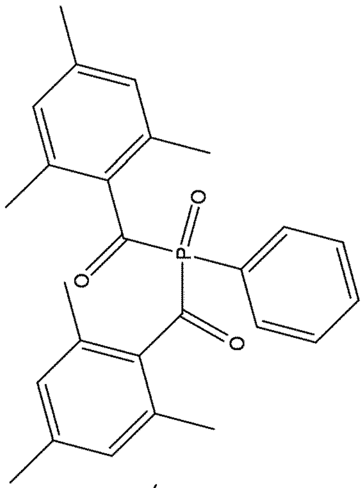 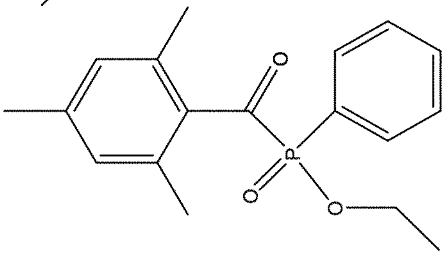 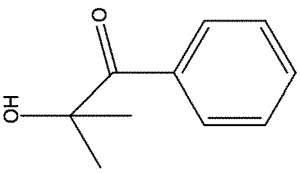 |

Die voranstehend genannten Photoinitiatoren können alleine oder in Kombination eingesetzt werden.

Vorzugsweise ist der Photoinitiator flüssig ist und/oder ausgewählt ist aus der Gruppe, bestehend aus 1,2-Octandion-1-[4-(phenylthio)-phenyl]-2-(O-benzoylo-xim), (1-[9-Ethyl-6-(2-methylbenzoyl)-9H-carbazol-3-yl]ethanon-O-acetyloxim, Methylbenzoylformiat), 2,4,6-Trimethylbenzoyl-diphenyl-phosphinoxid, Ethyl-(2,4,6-trimethylbenzoyl)-phenylphosphinat), 2-Hydroxy-2-methyl-1-phenylpropanon, einer Mischung aus 2-Hydroxy-2-methyl-1-phenylpropanon (80%) und 1-Hydroxycyclohexyl-phenylketon (20%), 1-Hydroxycyclohexyl-phenylketon, Bis(2,4,6-trimethylbenzoyl)phenylphosphinoxid, einer Mischung aus 2-Hydroxy-2-methyl-1-phenylpropanon, Bis(2,4,6-trimethylbenzoyl)phenylphosphinoxid und Ethyl(2,4,6-trimethylbenzoyl)-phenylphosphinat), und 4,4'-Dimethyl-diphenyl-iodonium-hexafluorphosphat.

## Monomer M1

Die flüssige Zusammensetzung II) des Kit-of-parts umfasst eine Mischung B umfassend mindestens ein Monomer M1, umfassend mindestens eine ethylenisch ungesättigte Gruppe, und vorzugsweise ein Monomer M2, umfassend mindestens zwei ethylenisch ungesättigte Gruppen, wobei sich M2 vorzugsweise von M1 nur durch die zweite ethylenisch ungesättigte Gruppe unterscheidet.

Dabei kann das Monomer M1, umfassend mindestens eine ethylenisch ungesättigte Gruppe, nachfolgende allgemeine Struktureinheiten aufweisen.

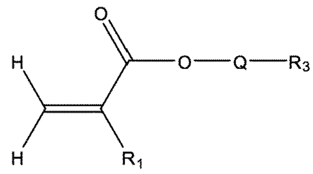

Acrylate

oder

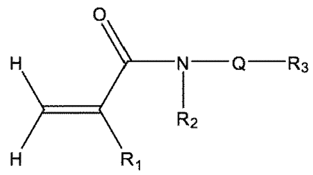

Acrylamide

oder

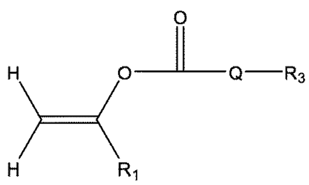

Vinylester

oder

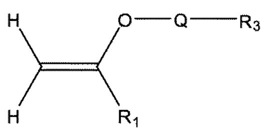

Vinylether

oder

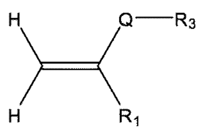

vinylische

oder

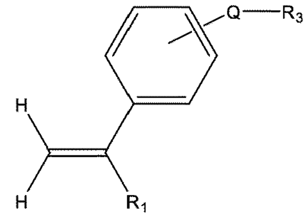

Styrole

wobei

$$Q = -\left(CH_2\right)_n-\left(O\right)_o- \quad \text{oder} \quad -\left(CH_2\right)_n-Ar-\left(CH_2\right)_m-\left(O\right)_o-$$

wobei n, m = 0-12, vorzugsweise 1-12; o = 0, 1; und Ar ein ein- oder mehrkerniger substituierter oder unsubstituierter aromatischer oder heterocyclischer aromatischer Rest ist,

wobei der Rest $R_1$ H, Methyl oder Ethyl ist und

wobei die Reste $R_2$ und $R_3$ unabhängig voneinander ausgewählt sind aus der Gruppe bestehend aus Alkyl-, Alkenyl-, Alkinyl-, Alkoxy-, Acyl- und Acyloxyreste, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte $\alpha$-licyclische Kohlenwasserstoffreste, aliphatische, aromatische und aliphatischaromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl-, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

Beispiele für geeignete Monomere M1 sind substituierte oder unsubstituierte Styrolmonomere, Acrylsäure, $\alpha$-Alkylacrylsäure, Acrylsäureester, $\alpha$-Alkylacrylsäureester, deren Alkoholkomponente ein substituierter oder unsubstituierter aliphatischer oder aromatischer Rest mit 2-50 Kohlenstoffatomen sein kann, Acrylamide, $\alpha$-Alkylacrylamide, wobei Alkyl die vorstehend angegebene Bedeutung hat, Vinylester, Vinylalkohol, Vinylether und sonstige substituierte vinylische Monomere, substituiert mit substituierten oder unsubstituierten aliphatischen oder aromatischen Resten mit 2-50 Kohlenstoffatomen.

Bevorzugte Beispiele für geeignete Monomere M1 sind (Meth)acrylsäurebutyles-ter, (Meth)acrylsäurephenylester, (Meth)acrylsäurebenzylester, (Meth)acrylsäu-reisobornylester, (Meth)acrylsäurecyclohexylester, (Meth)acrylsäure-2-phen-oxyethylester, (Meth)acrylsäure-1H,1H,2H,2H-perfluoroctylester, 2,2,2-Trifluorethyl(meth)acrylat, Heptafluorpropyl(meth)acrylat, 1,1,1,3,3,3-Hexyfluorisopro-pyl(meth)acrylat, 2,2,3,3-Tetrafluorpropyl(meth)acrylat), 2,2,3,3,4,4,4-Heptaflu-orbutyl(meth)acrylat, 2,2,3,3,4,4,5,5-Octafluorpentyl(meth)acrylat, AcrylsäureN,N-diethylaminoethylester, Acrylsäureethoxyethyoxyethylester, Acrylsäure-2-(p-chlorphenoxy)ethylester, p-Chlorphenylacrylat, 2-Phenylethyl(meth)acrylat, Pentachlorphenylacrylat, Phenylacrylat, p-Chlorstyrol, n-Vinylcarbazol, 1-Vinyl-2-pyrolidon, 2-Chlorstyrol, 2-Bromstyrol, Methoxystyrol, Phenolethoxylatacrylat, 2-(p-Chlorphenoxy)-ethylacrylat, 2-(1-Naphthyloxy)ethylacrylat, Hydrochinonmonomethacrylat und 2-[$\beta$-(N-Carbazolyl)propionyloxy]ethylacrylat.

Besonders bevorzugte Monomere M1 sind N-Vinylcarbazol, Ethoxyethoxyethylacrylat, 2-Naphthylacrylat, 2-Phenoxyethylacrylat, 2-Phenoxyethylmethacrylat, Phenolethoxylatacrylat, 2-(p-Chlorphenoxy)ethylacrylat, p-Chlorphenylacrylat, Phenylacrylat, 2-Phenylethylacrylat, 2-(1-Naphthyloxy)ethylacrylat, t-Butylacrylat, Isobornylacrylat, Cyclohexylacrylat, N,N-Diethylaminoethylacrylat, Acrylamid, Ethoxyethoxyethylacrylat, 1H,1H,2H,2H-Perfluoroctylmethacrylat und Pentafluorethylacrylat.

Vorzugsweise umfasst das Monomer M1 mindestens zwei ethylenisch ungesättigte Gruppen, daher ist das Monomer bevorzugt difunktionell.

Difunktionelle ethylenisch ungesättigte Monomere weisen zwei C-C-Doppelbindungen im Molekül auf, d.h. sie enthalten z.B. zwei der voranstehend angegebenen Struktureinheiten. Ein difuntionlles ethylenisch ungesättigtes Monomer kann z.B. zwei Acrylat- oder Methacrylatgruppen enthalten.

Das Monomer M1 in der erfindungsgemäßen monomerhaltigen flüssigen Mischung B kann ausschließlich aus einem oder mehreren difunktionellen oder höher funktionellen Monomer bestehen, d.h. die Zusammensetzung kann frei von monofunktionellen ethylenisch ungesättigten Monomeren sein. Bevorzugt beträgt der Gehalt an Monomeren M1 mit mindestens zwei ethylenisch ungesättigten Gruppen in der Mischung B mehr als 10 Gew.-%, besonders bevorzugt beträgt der Gehalt an Monomeren M1 mit mindestens zwei ethylenisch ungesättigten Gruppen mehr als 20 Gew.-%.

Die Verwendung von difunktionellen oder höher funktionellen Monomeren führt insbesondere zu einer besonders hohen thermischen und mechanischen Stabilität der hergestellten holographischen Elemente und ist insbesondere bei der Herstellung von Refexionshologrammen vorteilhaft.

Bevorzugte Monomere M1 mit mindestens zwei ethylenisch ungesättigten Gruppen sind ethoxylierte Bisphenol-A-Diacrylate, insbesondere Verbindungen der folgenden Formel

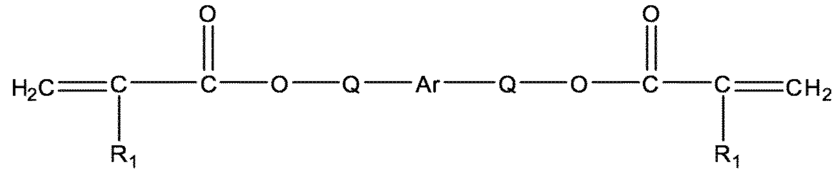

worin $R_1$, Q und Ar die oben angegebene Bedeutung haben.

Ein besonders bevorzugtes Monomer M1 ist die Verbindung der folgenden Strukturformel:

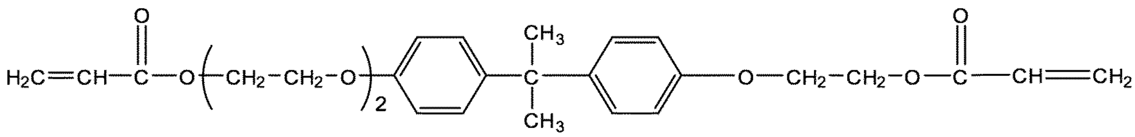

Bevorzugt beträgt die Viskosität des Monomers M1 bzw. Monomergemisches bei Raumtemperatur mindestens 900 mPa·s.

Die Viskosität der flüssigen Zusammensetzung II) beträgt ebenfalls bei 20°C mindestens 900mPa s, bevorzugt 1500mPa s und besonders bevorzugt mindestens 2000mPa s.

**Co-Photoinitiator**

Vorzugsweise umfasst der in dem erfindungsgemäßen Kip-of-parts verwendete Co-Photoinitiator eine Verbindung der Formel (I)

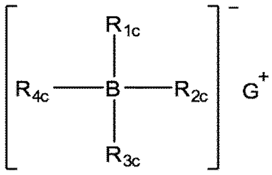

(I)

worin

$R_{1c}$ $C_1$-$C_{20}$-Alkyl, $C_3$-$C_{12}$-Cycloalkyl, $C_2$-$C_8$-Alkenyl, Phenyl-$C_1$-$C_6$-alkyl oder Naphtyl-$C_1$-$C_3$-alkyl bedeutet, wobei die Reste $C_1$-$C_{20}$-Alklyl, $C_3$-$C_{12}$-Cycloalkyl, $C_2$-$C_8$-Alkenyl, Phenyl-$C_1$-$C_6$-alkyl oder Naphtyl-$C_1$-$C_3$-alkyl mit einer oder mehreren Gruppen O, $S(O)_p$ oder $NR_{5c}$ unterbrochen sein können oder wobei die Reste $C_1$-$C_{20}$-Alkyl, $C_3$-$C_{12}$-Cycloalkyl, $C_2$-$C_8$-Alkenyl, Phenyl-$C_1$-$C_6$-alkyl oder Naphtyl-$C_1$-$C_3$-alkyl unsubstituiert oder mit $C_1$-$C_{12}$-Alkyl, $OR_6$, $R_{7c}S(O)_p$, $R_{7c}S(O)_2O$, $NR_{8c}R_{9c}$, $SiR_{10c}R_{11c}R_{12c}$, $BR_{13c}R_{14c}$ oder $R_{15c}R_{16c}P(O)_q$, substituiert sind; $R_{2c}$, $R_{3c}$ und $R_{4c}$ unabhängig voneinander Phenyl oder Biphenyl bedeuten, wobei die Reste Phenyl oder Biphenyl unsubstituiert oder mit unsubstituiertem oder mit $OR_{6c}$, $NR_{8c}R_{9c}$ oder Halogen substituiertem $C_1$-$C_{12}$-Alkyl, $OR_{6c}$, $R_{7c}S(O)_p$, $R_{7c}S(O)_2O$, $R_{8c}R_{9c}NS(O)_2$, $NR_{8c}R_{9c}$, $NR_{3c}R_{8c}CO$,

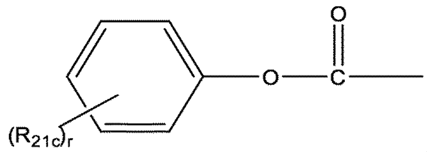 , 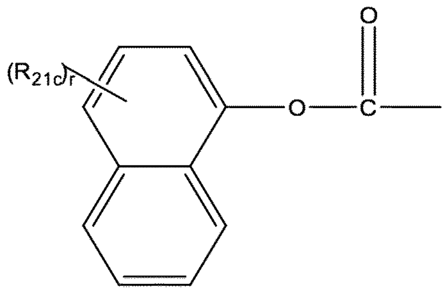

$SiR_{10c}R_{11c}R_{12c}$, $BR_{13c}R_{14c}$, Halogen, $R_{15c}R_{16c}P(O)_q$,

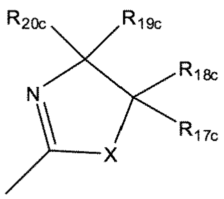 , 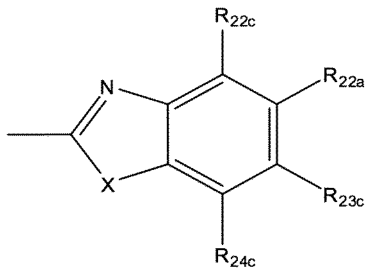 , 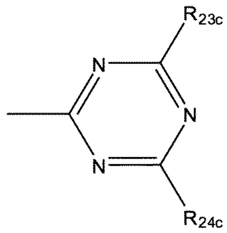

oder

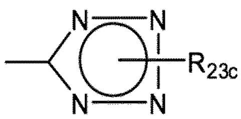

substituiert sind;

$R_{5c}$ Wasserstoff, $C_1$-$C_{12}$-Alkyl, unsubstituiertes oder ein- bis fünffach mit $C_1$-$C_6$-Alkyl, $C_1$-$C_{12}$-Alkoxy oder Halogen subsituiertes Phenyl-$C_1$-$C_6$-alkyl oder unsubstituiertes oder ein- bis fünffach mit $C_1$-$C_6$-Alkyl, $C_1$-$C_{12}$-Alkoxy oder Halogen subsituiertes Phenyl bedeutet;

$R_{6c}$ und $R_{7c}$ unsubstituiertes oder mit Halogen substituiertes $C_1$-$C_{12}$-Alkyl, unsubstituiertes oder ein- bis fünffach mit $C_1$-$C_6$-Alkyl, $C_1$-$C_{12}$-Alkoxy oder Halogen subsituiertes Phenyl-$C_1$- $C_6$-alkyl oder unsubstituiertes oder ein- bis fünffach mit $C_1$-$C_6$-Alkyl, $C_1$-$C_{12}$-Alkoxy oder Halogen subsituiertes Phenyl bedeuten;

$R_{8c}$, $R_{9c}$, $R_{10c}$, $R_{11c}$, $R_{12c}$, $R_{13c}$, $R_{14c}$, $R_{15c}$ und $R_{16c}$ unabhängig voneinander $C_1$-$C_{12}$-Alkyl, $C_3$-$C_{12}$-Cycloalkyl, unsubstituiertes oder ein- bis fünffach mit $C_1$-$C_6$-Alkyl, $C_1$-$C_{12}$-Alkoxy oder Halogen subsituiertes Phenyl-$C_1$-$C_6$-alkyl oder unsubstituiertes oder ein- bis fünffach mit $C_1$-$C_6$-Alkyl, $C_1$-$C_{12}$-Alkoxy oder Halogen subsituiertes Phenyl bedeuten, oder $R_{8c}$ und $R_{9c}$ zusammen mit dem N-Atom, an welches sie gebunden sind einen 6-gliedrigen aliphatischen Ring bilden, der außerdem als weiteres Heteroatom Sauerstoff oder Schwefel enthalten kann;

$R_{17c}$, $R_{18c}$, $R_{19c}$ und $R_{20c}$ unabhängig voneinander Wasserstoff, unsubstituiertes oder mit $C_1$-$C_{12}$-Alkoxy substituiertes $C_1$-$C_{12}$-Alkyl, Phenyl oder Phenyl-$C_1$-$C_6$-Alkyl bedeuten, wobei die Reste Phenyl oder Phenyl-$C_1$-$C_6$-Alkyl unsubstituiert oder ein- bis fünffach mit $C_1$-$C_6$-Alkyl, $C_1$-$C_{12}$-Alkoxy oder Halogen substituiert sind; p für eine Zahl von 0 bis 2 steht;

r für eine Zahl von 0 bis 5 steht;

$R_{21c}$ für Wasserstoff oder $C_1$-$C_{12}$-Alkyl steht;

$R_{22c}$, $R_{22a}$, $R_{23c}$ und $R_{24c}$ unabhängig voneinander Wasserstoff, unsubstituiertes oder mit $C_1$-$C_{12}$-Alkoxy, OH oder Halogen substituiertes $C_1$-$C_{12}$-Alkyl oder unsubstituiertes oder mit $C_1$-$C_{12}$-Alkoxy, OH oder Halogen substituiertes Phenyl bedeuten;

q entweder 0 oder 1 darstellt; und

G für einen Rest steht, welcher positive Ionen bilden kann.

Vorzugsweise ist der Co-Photoinitiator in dem erfingungsgemäßen Kit-of-parts ausgewählt ist aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus.

Ganz besonders bevorzugt ist ein Co-Photoinitiator mit der Strukturformel Ia, die unter der Bezeichnung "CGI 7460" von Ciba Specialty Chemicals Inc. entwickelt wurde und nun unter dem Namen SEC LCA 1460 bei der BASF AG erhältlich ist, wird wie folgt dargestellt:

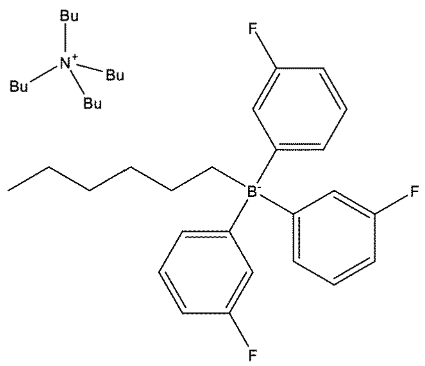

(Ia)

## Additive

Zur Anpassung an das gewählte Verarbeitungsverfahren oder das Einsatzgebiet des Kit-of-parts und zur Verbesserung der Druckbarkeit, Oberflächenhaftung, Viskosität, Filmbildung, Flexibilität, Härte, Kälte-, Hitze- und Witterungsbeständigkeit kann die flüssige Zusammensetzung oder die erste Mischung A verschiedene an sich bekannte Additive enthalten.

Daher umfasst das Farbstoffkonzentrat oder die flüssige Zusammensetzung optional ein Additiv.

Die Additive umfassen dabei Füllsubstanzen, Farbstoffe, Weichmacher, Tenside, übliche Komponenten, die in Photopolymersystemen verwendet werden, polymere Binder, Netzmittel, Verlaufsmittel, Entschäumer, Haftvermittler, Oberflächenadditive, nanoskalige Teilchen, optische Aufheller oder Mischungen daraus.

Diese sollen sich gut einmischen lassen und den Beugungswirkungsgrad nicht verschlechtern. Nicht flüchtige Substanzen können den Beugungswirkungsgrad bei dünnen Schichten sogar noch dauerhaft verbessern, indem insbesondere solche Additive gewählt werden, die den Brechungsindexunterschied zwischen dem ethylenisch ungesättigten Monomer und den übrigen Komponenten erhöhen. Daher kommen in diesem Fall neben bekannten Polymeren mit einem niedrigen Brechungsindex wie Polyvinylacetat besonders fluorierte oder silanisierte Polymere in Betracht. Um gute Diffusionseigenschaften zu erreichen, sollte das Molekulargewicht der in Betracht gezogenen Additive nicht zu hoch sein.

Die voranstehend erwähnten und nachfolgend im Einzelnen angegebenen Additive können im Allgemeinen in einer Menge von 0,01 bis 20 Gew.-%, bevorzugt 0,01 bis 10 Gew.-%, in Bezug auf der Gesamtmenge des Kit-of-parts, eingesetzt werden.

Das Kit-of-parts kann einen Weichmacher enthalten, um die Modulation des Brechungsindex der mit Bild versehenen Zusammensetzung zu verstärken. Weichmacher können in Mengen eingesetzt werden, die von etwa 0,01 bis etwa 10 Gew.-% reichen, vorzugsweise 5 bis etwa 10 Gew.-%, bezogen auf die Gesamtmenge des Kit-of-parts. Zu den geeigneten Weichmachern gehören Triethylenglykol, Triethylenglykoldiacetat, Triethylenglykoldipropionat, Triethylenglykoldicaprylat, Triethylenglykoldimethylether, Triethylenglykolbis(2-ethylhexanoat), Tetraethylenglykoldiheptanoat, Polyethylenglykol, Polyethylenglykolmethylether, Isopropylnaphthalin, Diisopropylnaphthalin,Polypropylenglykol, Glyceryltributyrat, Diethyladipat, Diethylsebacinat, Dibutylsuberinat, Tributylphosphat, Tris(2-ethylhexyl)phosphat, Brij® 30 [$C_{12}H_{25}(OCH_2CH_2)_4OH$], Brij® 35 [$C_{12}H_{25}(OCH_2CH_2)_{20}OH$], sowie n-Butylacetat.

Besonders bevorzugte Weichmacher sind Polyethylenglykol, Triethylenglykoldiethylhexanoat (3G8), Triethylenglykoldicaprylat, Tetraethylenglykoldiheptanoat, Diethyladipat, Brij® 30 und Tris(2-ethylhexyl)phosphat.

Falls gewünscht, können andere übliche Komponenten, die in PhotopolymerSystemen verwendet werden, mit den Zusammensetzungen und Elementen dieser Erfindung eingesetzt werden. Zu diesen Komponenten gehören: Optische Aufheller, ultraviolette Strahlung absorbierendes Material, thermische Stabilisatoren, Wasserstoff-Donoren, Sauerstoff-Fänger und Trennmittel. Diese Additive können auch Polymere oder Co-Polymere umfassen.

Zu den brauchbaren optischen Aufhellern gehören die im US-Patent 3 854 950 A offenbarten. Ein bevorzugter optischer Aufheller ist 7-(4'-Chlor-6'-diethylamino-1',3',5'-triazin-4'-yl)amino-3-phenylcumarin. Auch ultraviolette Strahlung absorbierende Materialien, die für diese Erfindung brauchbar sind, sind im US-Patent 3 854 950 A offenbart.

Zu den brauchbaren thermischen Stabilisatoren gehören: Hydrochinon, Phenidon, p-Methoxyphenol, Alkyl- und Aryl-substituierte Hydrochinone und Chinone, tert-Butylcatechin, Pyrogallol, Kupferresinat, Naphthylamine, β-Naphthol, Kupfer(I)-chlorid, 2,6-Di-tert-butyl-p-cresol, Phenothiazin, Pyridin, Nitrobenzol, Dinitrobenzol, p-Toluchinon und Chloranil. Brauchbar sind auch die in US-Patent 4 168 982 A beschriebenen Dinitroso-Dimere. Normalerweise ist auch ein Inhibitor für die thermische Polymerisation vorhanden, um die Stabilität bei der Lagerung der photopolymerisierbaren Zusammensetzung zu erhöhen.

Zu den als Kettenübertragungsreagenzien brauchbaren Wasserstoff-Donorverbindungen gehören: 2-Mercaptobenzoxazol, 2-Mercaptobenzothioazol etc. sowie verschiedene Arten von Verbindungen, z.B. (a) Ether, (b) Ester, (c) Alkohole, (d) Verbindungen, die allylischen oder benzylischen Wasserstoff enthalten wie etwa Cumol, (e) Acetale, (f) Aldehyde, und (g) Amide, wie offenbart in Spalte 12, Zeilen 18 bis 58 in US-Patent 3 390 996, auf die hierin ausdrücklich Bezug genommen wird.

Verbindungen, die sich als Trennmittel brauchbar erwiesen haben, sind beschrieben in US-Patent 4 326 010 A. Ein bevorzugtes Trennmittel ist Polycaprolacton.

Das Kit-of-parts kann auch einen oder mehrere polymere Binder enthalten, der bzw. die ausgewählt ist aus der Gruppe umfassend Polymethylmethacrylat und Polyethylmethacrylat, Polyvinylester, wie Polyvinylacetat, Polyvinylacetat/-acrylat, Polyvinylacetat/-methacrylat und teilweise hydrolisiertes Polyvinylacetat, Ethylen/Vinylacetat-Copolymere, Vinylchlorid/Carbonsäurester-Copolymere, Vinylchlorid/Acrylsäureester-Copolymere, Polyvinylbutyral und Polyvinylformal, Butadien und Isoprenpolymere und Copolymere und Polyethylenoxide aus Polyglykolen mit einem durchschnittlichen Molekulargewicht von etwa 1.000 bis 1.000.000 g/mol, Epoxide, wie Acrylat- oder Methacrylatreste enthaltende Epoxide, Polystyrole, Celluloseester, wie Celluloseacetat, Celluloseacetatsuccinat und Celluloseacetatbutyrat, Celluloseether, wie Methylcellulose und Ethylcellulose, Polykondensate, wie Polycarbonate, Polyester, Polyamide, wie N-Methoxymethylpolyhexamethylenadipamid, Polyimide, Polyurethane. Die genannten polymeren Binder können z.B. in einer Menge von 0,001 bis 10 Gew.-%, bezogen auf das Gesamtgewicht des Kit-of-parts, eingesetzt werden.

Das Kit-of-parts kann auch ein oder mehrere Netzmittel (insbesondere Fluor-Carbonpolymere, wie zum Beispiel Schwego-Fluor 8038™, oder Fluorotenside, wie zum Beispiel 3M Fluorad FC-4430™), Verlaufsmittel (insbesondere Glykolsäuren-butylester oder Polyether-modifizierte Polydimethylsiloxane, wie zum Beispiel ADDID 130™), Entschäumer (insbesondere Entschäumer auf Fluorsilikonölbasis, wie zum Beispiel ADDID 763™), Haftvermittler (insbesondere Diamino-Trimethoxy-funktionelle Silanhaftvermittler, wie zum Beispiel ADDID 900™ oder Glycidyl-Trimethoxytrifunktionelle Silanhaftvermittler, wie zum Beispiel ADDID 911 ™, Vinyltriethyoxysilan oder 3-Methacryloxypropyltrimethoxysilan), oder Oberflächenadditive (insbesondere Polyether-modifizierte acrylfunktionelle Polydimethylsiloxane, wie zum Beispiel BYK-UV 3500™, Polyether-modifizierte Polydimethylsiloxane, wie zum Beispiel BYK-UV 3510™ oder Polyether-modifizierte acrylfunktionelle Polydimethylsiloxane, wie zum Beispiel BYK-UV 3530™) enthalten. Die genannten Produkte mit den Handelsnahmen "ADDID" bzw. "BYK" sind von Wacker bzw. BYK Chemie erhältlich.

Das Kit-of-parts kann auch nanoskalige Teilchen wie z.B. $TiO_2$, $SiO_2$ oder Au enthalten, die ggf. an Monomere gekoppelt sein können (solche Materialien sind z.B. unter der Handelsbezeichnung "Nanocryl" erhältlich).

Vorzugsweise kann das Additiv ein Aminsynergist sein. Ein Aminsynergist kann in Kombination mit anderen Photoinitiatoren die Aushärtungsgeschwindigkeit von UV-Lacken erhöhen (siehe DE 60216490 T2).

Vorzugsweise kann das Additiv ein Peroxid sein. Ein thermisch aktivierbarer Peroxid kann in Kombination mit anderen Photoinitiatoren die Aushärtung von UV-Lacken besonders in Schattenbereichen verbessern (siehe US 5017406 A oder DE 60030223 T2).

Vorzugsweise kann das Additiv auch ein Marker ausgewählt aus Fluoreszenzpigmenten oder Lanthanidverbindungen sein. Als Lanthanidverbindungen können beispielsweise Europium oder Terbium Trisdipicolinat Komplexe verwendet werden.

Unter einem Marker wird im Sinne der vorliegenden Erfindung eine forensisch nachweisbare Substanz verstanden, über die die Authentizität oder die Herkunft eines Produktes bzw. dessen Produzent oder Verkäufer ermittelt werden kann. Vorausgesetzt, dass die zu erzeugenden Schichten dick genug sind um die entsprechenden Mikropartikel einzubetten, können auch kleine individualisierte Partikel, buntes Mikroplastik auch Taggant genannt, eingebracht werden

Die flüssige Zusammensetzung kann zudem ein Triglycerid und/oder ein modifiziertes Triglycerid umfassen.

Die geeigneten Triglyceride sind allgemein Verbindungen der folgenden allgemeinen Strukturformel

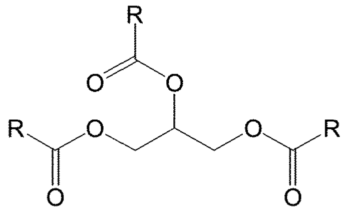

worin die R, jeweils unabhängig voneinander, für einen Fettsäurerest stehen; bevorzugt enthält R jeweils 6 bis 22, mehr bevorzugt 8 bis 18, Kohlenstoffatome.

Als Triglycerid können auch natürlich vorkommende Öle oder Fette wie z.B. Rizinusöl, Kokosöl, Palmkernöl und Gemische davon eingesetzt werden. Auch Derivate (z.B. Hydrierungsprodukte) solcher natürlichen Fette und Öle können eingesetzt werden. Solche natürlich vorkommenden Öle oder Fette sind bzw. enthalten im allgemeinen Gemische verschiedener Triglyceride.

Ein besonders bevorzugtes Triglycerid ist das Triglycerid der Ricinolsäure, das ein Hauptbestandteil des Rizinusöls ist.

Bevorzugt wird das Triglycerid so gewählt, dass der Betrag der Differenz zwischen dem Brechungsindex (n) des ethylenisch ungesättigten Monomers oder Monomergemisches und dem Brechungsindex des Triglycerids (d.h. ln(Monomer) - n(Triglycerid)|) bei 20°C mindestens 0,02, mehr bevorzugt mindestens 0,05, am meisten bevorzugt mindestens 0,07 beträgt.

Als modifiziertes Triglycerid kommen beispielsweise ethyoxylierte Rizinusöle bzw. deren Ricinolsäuren in Betracht. Vorzugsweise umfasst das modifizierte Triglycerid ethoxylierte Triglyceride mit 25 bis 250 Einheiten basierend auf Etylenoxid. Beispielsweise kann Hedipin R/2000 auch als "PEG-200 castoir oil" bekannt) verwendet werden.

Hedipin R/2000 wird hergestellt, indem Rizinusöl mit Ethylenoxid in einem molaren Verhältnis von 1:200 umgesetzt wird. Rizinusöl ist eine Mischung aus Triglyceriden, das aus den Samen von *Ricinus communis* gewonnen wird. Der Hauptbestandteil von Rizinusöl (>80%) ist das Triglycerid der Ricinolsäure. Hedipin R/2000 enthält eine Mischung polyethoxylierter Triglyceride, wobei die polyethoxlierten Produkte des Triglycerids der Ricinolsäure den Hauptbestandteil bilden. Die polyethoxlierten Produkte des Triglycerids der Ricinolsäure umfassen eine oder mehrere der Verbindungen der Formel A, B und C und Mischungen davon, sowie alle Stereoisomere davon. Als weitere Bestandteile kann Hedipin R/2000 Polyoxyethylenricinoleate, freie Polyethylenglykole und ethoxylierte Glycerine umfassen.

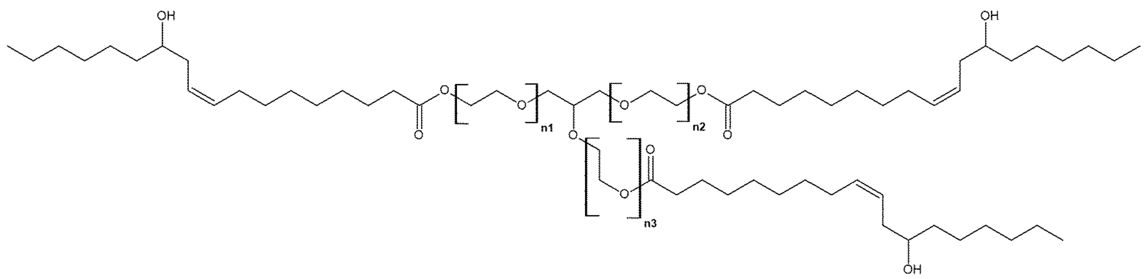

Formel (A)

In der Formel (A) sind n1, n2 und n3 unabhängig voneinander eine ganze Zahl von 0-200, bevorzugter von 10-180, bevorzugter von 20-150, bevorzugter von 30-130, bevorzugter von 40-110, bevorzugter von 50-90, bevorzugter von 60-75, wobei $n^1$+n2+n3 = 150-250.

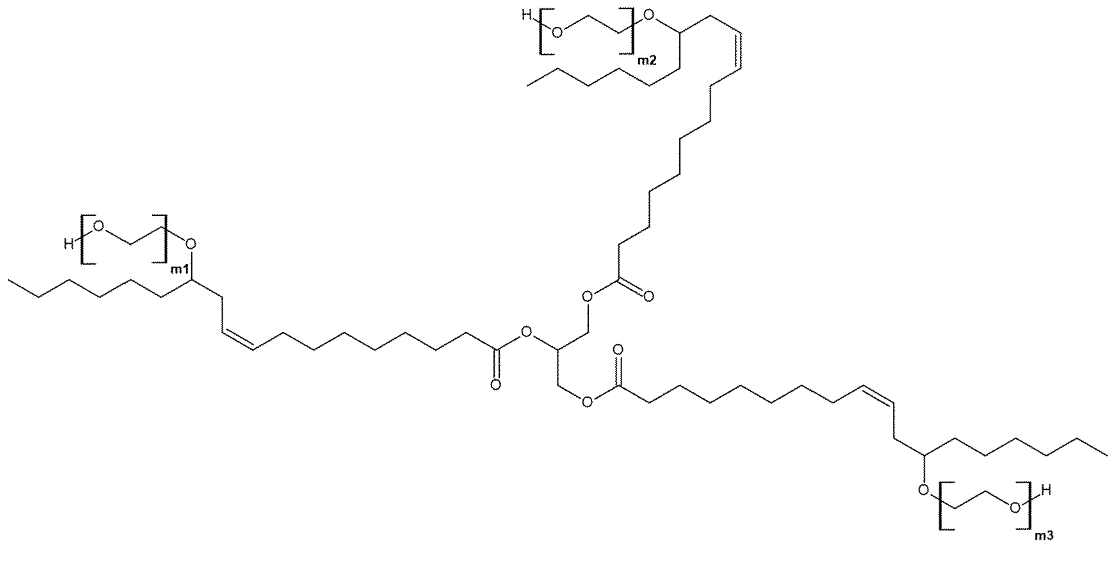

Formel (B)

In der Formel (B) sind m1, m2 und m3 unabhängig voneinander eine ganze Zahl von 0-200, bevorzugter von 10-180, bevorzugter von 20-150, bevorzugter von 30-130, bevorzugter von 40-110, bevorzugter von 50-90, bevorzugter von 60-75, wobei m1+m2+m3 = 150-250.

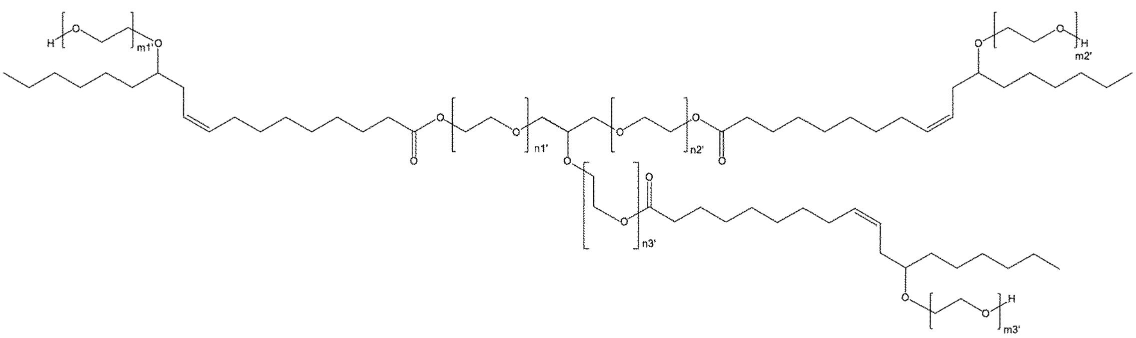

Formel (C)

In der Formel (C) sind n1', n2' und n3' jeweils unabhängig voneinander eine ganze Zahl von 0-200, bevorzugter von 5-175, bevorzugter von 10-150, bevorzugter von 15-125, bevorzugter von 20-100, bevorzugter von 20-75, bevorzugter von 25-40, wobei n1'+n2'+n3' = 50-150.

In der Formel (C) sind m1', m2' und m3' jeweils unabhängig voneinander eine ganze Zahl von 0-200, bevorzugter von 5-175, bevorzugter von 10-150, bevorzugter von 15-125, bevorzugter von 20-100, bevorzugter von 20-75, bevorzugter von 25-40, n1'+n2'+n3' = 50-150.

Bevorzugt sind in der Formel (C) n1', n2', n3', m1', m2' und m3' jeweils unabhängig voneinander eine ganze Zahl von 10-150, bevorzugter von 15-125, bevorzugter von 20-100, bevorzugter von 20-75, bevorzugter von 25-40, wobei n1'+n2'+n3'+m1'+m2'+m3' = 150-250.

Die Verwendung von Triglyceriden bzw. modifizierten Triglyceriden hat weitere Vorteile: Die photopolymerisierbare Zusammensetzung weist eine verringerte Oberflächenhaftung und Flexibilität auf, da das Triglycerid bzw. das modifizierte Triglycerid gleichzeitig als Trennmittel und Weichmacher fungiert. Ein belichtetes Hologramm kann daher leicht und restlos von einem Substrat, wie z.B. Glas oder Metall, entfernt werden. Auch diese Eigenschaft ist für die Massenproduktion sehr günstig, weil somit verschleißfrei Kopiermaster, wie herkömmliche Nickelshims mit einer feinen holographischen Oberflächenstruktur oder mit Dünnglas versiegelte Volumenhologramme, für die Anfertigung von Kontaktkopien verwendet werden können. Durch die restlose Entfernung der nicht klebrigen Schicht bleibt der Reinigungsaufwand gering. Wenn die flüssige photopolymerisierbare Zusammensetzung direkt auf das Master aufgedruckt wird, entfällt auch das Indexmatching. Darunter wird das Auftragen einer Flüssigkeit zwischen Master und Hologrammschicht

mit ungefähr dem gleichen Brechungsindex der beiden Schichten verstanden. Das Indexmatching verhindert beim normalen Kontaktkopierverfahren das Auftreten von störenden Interferenzerscheinungen (Newtonringe). Diese entstehen durch Reflexionen, die besonders an den Stellen auftreten, wo sich die beiden Schichten z. B. wegen eines Staubeinschlusses oder einer kleinen Unebenheit nicht direkt berühren. Der Ausgleich von Kratzern und anderen Unebenheiten im Trägermaterial oder auf dem Master verbessert zudem die optische Qualität der Kopie. Kleine Staubteilchen mit einer geringeren Abmessung als die Schichtdicke werden in der Flüssigkeit eingebettet und erzeugen keine deutlichen Druck- und Fehlstellen wie bei den Filmmaterialien. Dies verringert den Ausschuss und die Reinraumansprüche an die Produktionsumgebung wesentlich.

Der lückenlose Kontakt zwischen Aufzeichnungsmaterial und Master kann auch dazu genutzt werden, auf dem Master vorhandene Oberflächenstrukturen abzuformen. Solche Oberflächenstrukturen können insbesondere Prägehologramme oder Fresnelstrukturen sein. Dadurch ist es möglich, in einem einzelnen Verarbeitungsschritt sowohl die Oberflächenstruktur als auch die volumenholographische oder optische Information des Masters zu kopieren.

Die flüssige Zusammensetzung kann zudem mindestens einen aromatischen Aldehyd und/oder aliphatischen Aldehyd umfassen.

Vorzugsweise ist der aromatische Aldehyd ausgewählt aus der Gruppe, bestehend aus Vanillin, Coniferylaldehyd, 2-Methoxybenzaldehyd, 3-Methoxybenzaldehyd, 4-Methoxybenzaldehyd, 2-Ethoxybenzaldehyd, 3-Ethoxybenzaldehyd, 4-Ethoxybenzaldehyd, 4-Hydroxy-2,3-dimethoxy-benzaldehyd, 4-Hydroxy-2,5-dimethoxy-benzaldehyd, 4-Hydroxy-2,6-dimethoxy-benzaldehyd, 4-Hydroxy-2-methyl-benzaldehyd, 4-Hydroxy-3-methyl-benzaldehyd, 4-Hydroxy-2,3-dimethyl-benzaldehyd, 4-Hydroxy-2,5-dimethyl-benzaldehyd, 4-Hydroxy-2,6-dimethyl-benzaldehyd, 4-Hydroxy-3,5-dimethoxy-benzaldehyd, 4-Hydroxy-3,5-dimethyl-benzaldehyd, 3,5-Diethoxy-4-hydroxy-benzaldehyd, 2,6-Diethoxy-4-hydroxybenzaldehyd, 3-Hydroxy-4-methoxy-benzaldehyd, 2-Hydroxy-4-methoxy-benzaldehyd, 2-Ethoxy-4-hydroxybenzaldehyd, 3-Ethoxy-4-hydroxy-benzaldehyd, 4-Ethoxy-2-hydroxy-benzaldehyd, 4-Ethoxy-3-hydroxy-benzaldehyd, 2,3-Dimethoxybenzaldehyd, 2,4-Dimethoxybenzaldehyd, 2,5-Dimethoxybenzaldehyd, 2,6-Dimethoxybenzaldehyd, 3,4-Dimethoxybenzaldehyd, 3,5-Dimethoxybenzaldehyd, 2,3,4-Trimethoxybenzaldehyd, 2,3,5-Trimethoxybenzaldehyd, 2,3,6-Trimethoxybenzaldehyd, 2,4,6-Trimethoxybenzaldehyd, 2,4,5-Trimethoxybenzaldehyd, 2,5,6-Trimethoxybenzaldehyd, 2-Hydroxybenzaldehyd, 3-Hydroxybenzaldehyd, 4-Hydroxybenzaldehyd, 2,3-Dihydroxybenzaldehyd, 2,4-Dihydroxybenzaldehyd, 2,4-Dihydroxy-3-methyl-benzaldehyd, 2,4-Dihydroxy-5-methyl-benzaldehyd, 2,4-Dihydroxy-6-methyl-benzaldehyd, 2,4-Dihydroxy-3-methoxy-benzaldehyd, 2,4-Dihydroxy-5-methoxy-benzaldehyd, 2,4-Dihydroxy-6-methoxy-benzaldehyd, 2,5-Dihydroxybenzaldehyd, 2,6-Dihydroxybenzaldehyd, 3,4-Dihydroxybenzaldehyd, 3,4-Dihydroxy-2-methyl-benzaldehyd, 3,4-Dihydroxy-5-methyl-benzaldehyd, 3,4-Dihydroxy-6-methyl-benzaldehyd, 3,4-Dihydroxy-2-methoxybenzaldehyd, 3,4-Dihydroxy-5-methoxy-benzaldehyd, 3,5-Dihydroxybenzaldehyd, 2,3,4-Trihydroxybenzaldehyd, 2,3,5-Trihydroxybenzaldehyd, 2,3,6-Trihydroxybenzaldehyd, 2,4,6-Trihydroxybenzaldehyd, 2,4,5-Trihydroxybenzaldehyd, 3,4,5-Trihydroxybenzaldehyd, 2,5,6-Trihydroxybenzaldehyd, 4-Hydroxy-2-methoxybenzaldehyd, 4-Dimethylaminobenzaldehyd, 4-Diethylaminobenzaldehyd, 4-Dimethylamino-2-hydroxybenzaldehyd, 4-Diethylamino-2-hydroxybenzaldehyd, 4-Pyrrolidinobenzaldehyd, 4-Morpholinobenzaldehyd, 2-Morpholinobenzaldehyd, 4-Piperidinobenzaldehyd, 2-Methoxy-1-naphthaldehyd, 4-Methoxy-1-naphthaldehyd, 2-Hydroxy-1-naphthaldehyd, 2,4-Dihydroxy-1-napthaldehyd, 4-Hydroxy-3-methoxy-1-naphthaldehyd, 2-Hydroxy-4-methoxy-1-naphthaldehyd, 3-Hydroxy-4-methoxy-1-naphthaldehyd, 2,4-Dimethoxy-1-naphthaldehyd, 3,4-Dimethoxy-1-naphthaldehyd, 4-Hydroxy-1-naphthaldehyd, 4-Dimethylamino-1-naphthaldehyd, 4-Dimethylaminozimtaldehyd, 2-Dimethylaminobenzaldehyd, 2-Chlor-4-dimethylaminobenzaldehyd, 4-Dimethylamino-2-methylbenzaldehyd, 4-Diethylamino-zimtaldehyd, 4-Dibutylamino-benzaldehyd, 4-Diphenylamino-benzaldehyd, 4-Dimethylamino-2-methoxybenzaldehyd, 4-(1-Imidazolyl)-benzaldehyd, Piperonal, 2,3,6,7-Tetrahydro-1H,5H-benzo[ij]chinolizin-9-carboxaldehyd, 2,3,6,7-Tetrahydro-8-hydroxy-1H,5H-benzo[ij]chinolizin-9-carboxaldehyd, N-Ethylcarbazol-3-aldehyd, 2-Formylmethylen-1,3,3-trimethylindolin (Fischers Aldehyd oder Tribasen Aldehyd), 2-Indolaldehyd, 3-Indolaldehyd, 1-Methylindol-3-aldehyd, 2-Methylindol-3-aldehyd, 1-Acetylindol-3-aldehyd, 3-Acetylindol, 1-Methyl-3-acetylindol, 2-(1',3',3'-Trimethyl-2-indolinyliden)-acetaldehyd, 1-Methylpyr-rol-2-aldehyd, 1-Methyl-2-acetylpyrrol, 4-Pyridinaldehyd, 2-Pyridinaldehyd, 3-Pyridinaldehyd, 4-Acetylpyridin, 2-Acetylpyridin, 3-Acetylpyridin, Pyridoxal, Chinolin-3-aldehyd, Chinolin-4-aldehyd, Antipyrin-4-aldehyd, Furfural, 5-Nitrofurfural, 2-Thenoyl-trifluor-aceton, Chromon-3-aldehyd, 3-(5'-Nitro-2'-furyl)-acrolein, 3-(2'-Furyl)-acrolein und Imidazol-2-aldehyd.

Besonders bevorzugt ist der aromatische Aldehyd ausgewählt aus der Gruppe, bestehend aus 2,3-Dihydroxybenzaldehyd, 2,4-Dihydroxybenzaldehyd, 2,4-Dihydroxy-3-methyl-benzaldehyd, 2,4-Dihydroxy-5-methyl-benzaldehyd, 2,4-Dihydroxy-6-methyl-benzaldehyd, 2,4-Dihydroxy-3-methoxy-benzaldehyd, 2,4-Dihydroxy-5-methoxy-benzaldehyd, 2,4-Dihydroxy-6-methoxy-benzaldehyd, 2,5-Dihydroxybenzaldehyd, 2,6-Dihydroxybenzaldehyd, 3,4-Dihydroxybenzaldehyd, 3,4-Dihydroxy-2-methyl-benzaldehyd, 3,4-Dihydroxy-5-methyl-benzaldehyd, 3,4-Dihydroxy-6-methyl-benzaldehyd, 3,4-Dihydroxy-2-methoxy-benzaldehyd, 3,4-Dihydroxy-5-methoxy-benzaldehyd, 3,5-Dihydroxybenzaldehyd.

Ganz besonders bevorzugt ist der aromatische Aldehyd ausgewählt aus der Gruppe, bestehend aus 2,4-Dihydroxybenzaldehyd, 2,5-Dihydroxybenzaldehyd, 2,6-Dihydroxybenzaldehyd und 3,5-Dihydroxybenzaldehyd.

Besonders bevorzugt ist ein Kit-of-parts zur Herstellung einer photopolymerisierbaren Zusammensetzung mittels UV/Vis-Bestrahlung, umfassend:

I) ein Farbstoffkonzentrat, umfassend

A) eine erste Mischung A, insbesondere flüssige Mischung A, umfassend

f) mindestens einen Farbstoff ausgewählt aus der Gruppe, bestehend aus Acriflavinen, Diaminoacridinen, Rhodamin B, Safranin-O, Diethylsafraninen und Methylenblau.
und
h) mindestens ein Lösungsmittel ausgewählt aus der Gruppe, bestehend aus Dimethylsulfoxid (DMSO), N,N'-Dimethylpropylenharnstoff, N-Hydroxyethylacrylamid (HEAA), N-Methyl-2-pyrrolidon (NMP), Benzaldehyd, Polyethylenglykolen (PEGs), Polycaprolactonen, Acrylat-Block-Copoylmeren (EFKA) und Poly(Bisphenol-A-co-epichlorhydrinen).

und
II) eine flüssige Zusammensetzung umfassend:
B) eine monomerhaltige flüssige Mischung B, umfassend:

a) mindestens ein Monomer M1, umfassend mindestens eine ethylenisch ungesättigte Gruppe,
c) mindestens einen Co-Photoinitiator ausgewählt aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus.

Besonders bevorzugt ist ein Kit-of-parts zur Herstellung einer photopolymerisierbaren Zusammensetzung mittels UV/Vis-Bestrahlung, umfassend:

I) ein Farbstoffkonzentrat, umfassend

A) eine erste Mischung A, insbesondere flüssige Mischung A, umfassend

f) mindestens einen Farbstoff ausgewählt aus der Gruppe, bestehend Acriflavinen, Diaminoacridinen, Rhodamin B, Safranin-O, Diethylsafraninen und Methylenblau,
g) mindestens einen Photoinitiator und
h) mindestens ein Lösungsmittel

und
II) eine flüssige Zusammensetzung umfassend:
B) eine monomerhaltige flüssige Mischung B, umfassend:

a) mindestens ein Monomer M1, umfassend mindestens eine ethylenisch ungesättigte Gruppe,
c) mindestens einen Co-Photoinitiator ausgewählt aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus.

Vorzugsweise umfasst das Kit-of-parts höchstens 10 Gew.-% einer ersten Mischung A, bezogen auf die Gesamtmenge der Mischung B.

Ganz besonders bevorzugt ist ein Kit-of-parts zur Herstellung einer photopolymerisierbaren Zusammensetzung mittels UV/Vis-Bestrahlung, umfassend:

I) 0,1 bis 5 Gew.-% eines Farbstoffkonzentrates, umfassend

A) eine erste Mischung A, umfassend

f) mindestens einen Farbstoff ausgewählt aus der Gruppe, bestehend Acriflavinen, Diaminoacridinen, Rhodamin B, Safranin-O, Diethylsafraninen und Methylenblau,
g) mindestens einen Photoinitiator und
h) mindestens ein Lösungsmittel

und
II) 95 bis 99,9 Gew.-% einer flüssigen Zusammensetzung umfassend:

B) eine monomerhaltige flüssige Mischung B, umfassend:

a) mindestens ein Monomer M1, umfassend mindestens eine ethylenisch ungesättigte Gruppe,
c) mindestens einen Co-Photoinitiator ausgewählt aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus, wobei die Gesamtmenge von I) und II) 100 Gew.% ergibt.

Vorzugsweise umfasst das Kit-of-parts höchstens 10 Gew.-% einer ersten Mischung A, bezogen auf die Gesamtmenge der Mischung B.
Ganz besonders bevorzugt ist ein Kit-of-parts zur Herstellung einer photopolymerisierbaren Zusammensetzung mittels UV/Vis-Bestrahlung, umfassend:

I) 0,1 bis 5 Gew.-% eines Farbstoffkonzentrates, umfassend

A) eine erste Mischung A, umfassend

f) 0,5 bis 5 Gew.-% mindestens eines Farbstoffs ausgewählt aus der Gruppe, bestehend Acriflavinen, Diaminoacridinen, Rhodamin B, Safranin-O, Diethylsafraninen und Methylenblau,
g) 9,5 bis 99,5 Gew.-% mindestens eines Photoinitiators und
h) 0 bis 90 Gew.-% mindestens eines Lösungsmittels, wobei die Gesamtmenge von f) bis h) 100 Gew.-% ergibt

und
II) 95 bis 99,9 Gew.-% einer flüssigen Zusammensetzung umfassend:
B) eine monomerhaltige flüssige Mischung B, umfassend:

a) 49,9 bis 99,9 Gew.-% mindestens eines Monomers M1, umfassend mindestens eine ethylenisch ungesättigte Gruppe,
c) 0,1 bis 10 Gew.-% mindestens eines Co-Photoinitiators ausgewählt aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus, wobei die Gesamtmenge von a) und c) mindestens 50% und nicht mehr als 100 Gew.-% ergibt

und wobei die Gesamtmenge von I) und II) 100 Gew.% ergibt.

Ein weiterer Gegenstand der Erfindung ist ein Element, enthaltend eine Komponente, die erhältlich ist durch die Einwirkung von (aktinischer) UV/VIS-Strahlung auf die aus dem erfindungsmäßen Kit-of-parts hergestellte photopolymerisierbare Zusammensetzung.
Bevorzugt ist ein Element umfassend ein Hologramm, das erhältlich ist durch die Einwirkung einer holographischen Information tragenden, modulierten Strahlung auf die photopolymerisierbare Zusammensetzung des erfindungsmäßen Kit-of-parts. Dazu kann vorteilhafterweise die photopolymerisierbare Zusammensetzung aus dem Kit-of-parts auf einem Substrat, beispielsweise ein Spiegelblech, einenOberflächenspiegel, ein Nickelshim mit holographischen oder optischen Oberflächenstrukturen oder auf ein Masterhologramm aufgetragen werden und mit einem Laserstrahl belichtet werden, so das ein Hologramm entsteht. Danach wird vorteilhafterweise die photopolymerisierbare Zusammensetzung aus dem Kit-of-parts noch mit UV-Licht gehärtet.
Ein weiterer Gegenstand der Erfindung ist Verwendung des erfindungsmäßen Elements als Folie, Linse, Gitter, Prisma, Spiegel, Strahlteiler, Diffusor, Oberflächenrelief, Membran, Filter oder Sensor.
Bevorzugt ist die Verwendung des erfindungsmäßen Elements für ein für ein Head-up-Display, eine Datenbrille, ein Lichtleitsystem, ein Spektrometer, ein Detektionssystem, ein Sicherheitselement oder ein Label.
Vorteilhafterweise greift oder verändert das Farbstoffkonzentrat vorher belichtete Hologrammschichten nicht.

**Vorteile des Kit-of-parts**

- nach der Anmischung sofort belichtbar
- keine Wartezeiten und zeitliche Änderungen der Materialeigenschaften durch Abdampfen und Konzentrationsänderungen des Lösemittels
- keine gesundheits- und umweltschädliche Dämpfe
- kein Ex-Schutz notwendig
- gute Verträglichkeit, keine Verschlechterung der Hologrammeigenschaften
- vorher belichtete Hologrammschichten werden nicht angegriffen oder verändert
- die getrennte Aufbewahrung von Farbstoffkonzentrat und Hologrammmaterial verbessert die Haltbarkeit und vereinfacht die Lagerung. Das Material ist dadurch weniger Licht- und wärmeempfindlich
- Die aus dem Kit of Parts herstellbaren photopolymerisierbaren Zusammensetzungen können anwendungsbezogen auf die Belichtungsart und den gewünschten Ergebnissen individuell angepasst werden. Über die Wahl des passenden Farbstoffkonzentrates und die Variation der Menge kann abhängig von der Schichtdicke, der gewünschten Empfindlichkeit und der tolerierbaren Farbtonung im fertigen Produkt die optimale Farbintensität eingestellt werden
- die verwendeten Stoffe verschlechtern nicht oder verbessern sogar die holographischen Eigenschaften der photopolymerisierbaren Zusammensetzung
- die Qualität der Kit-of-parts kann bei normalen Umgebungslicht beurteilt werden
- durch die kurze Zeitspanne zwischen Anmischung, Auftragung und Belichtung sind die Ansprüche an die Farbe und Helligkeit des Umgebungslichts gering.

**Beispiele**

**Abkürzungsverzeichnis**

| | |
|---|---|
| BWG, $\eta$ | Beugungswirkungsgrad |
| CN 9002 | Aliphatisches Urethan Acrylat |
| DMSO | Dimethylsulfoxid |
| Ebecryl 230 | Aliphatisches Urethan Diacrylat |
| EFKA | Acryl Block Copolymer |
| EPI | Poly(Bisphenol A-co-epichloro-hydrin) glycidyl end-capped |
| Hedipin R/2000 | Ethoxyliertes Rizinusöl |
| HEAA | N-Hydroxyethylacrylamid |
| Irgacure OXE01 | Oxime-ester Radikalinitiator [1-(4-phenylsulfanylbenzoyl)heptylideneamino]benzoat |
| NPG | N-Phenylglycin |
| Omnirad 1173 | 2-Hydroxy-2-methyl-1-phenylpropanon |
| PCL-triol | Poly-(caprolacton)-triol, $M_n$ ~300 |
| PEG-200 | Polyethylenglykol, $M_n$ -200 |
| PEG-PP-PEG | Poly(ethylenglykol)-block-poly(propylenglykol)-block-poly(ethylenglykol |
| PolyCLO | Capromer PT-05, Polycaprolacton, $M_n$ -540 |
| SEC LCA 1460 | Boratsalz, Co-Initiator |
| SR 349 | Ethoxyliertes Bisphenol A Diacrylat |
| $T_{Peak}$ | Peakwert, Transmission bei der Wellenlänge, welche die Bragg-Bedingung erfüllt |
| $T_{Ref}$ | Referenzwert, Transmission ohne Hologramm |

**Farbstoffe**

Als besonders geeignete Farbstoffe erwiesen sich Molekülstrukturen mit einem Hauptgerüst aus drei Benzolringen.

Beispiele

| **Belichtung mit** | **Farbstoff** | **Molekül** | CAS |
|---|---|---|---|
| grün | Safranin-O | 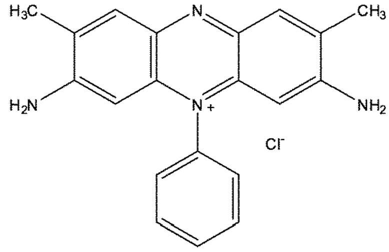 | 477-73-6 |
| gelb | Diethylsafranin | 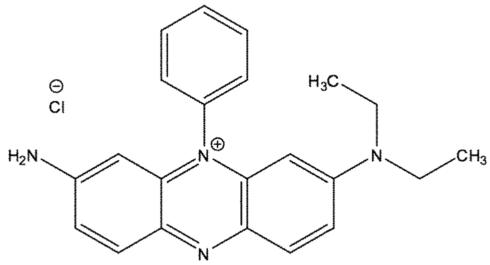 | 4569-86-3 |
| gelb | Rhodamin-B | 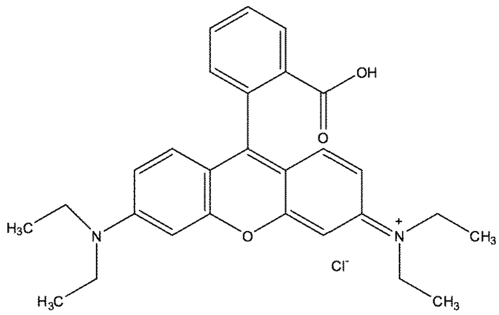 | 81-88-9 |
| rot | Methylenblau | 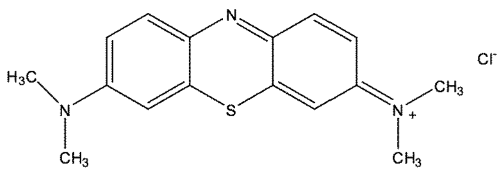 | 61-73-4 |
| blau | Acriflavine | 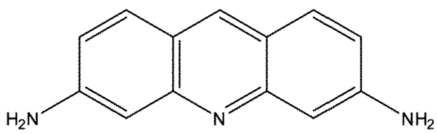 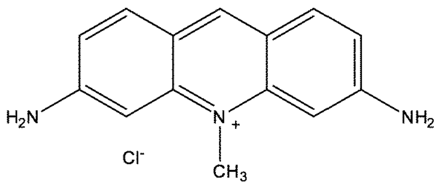 | 8048-52-0 |

(fortgesetzt)

| **Belichtung mit** | **Farbstoff** | **Molekül** | CAS |
|---|---|---|---|
| blau | Acriflavine hydrochloride | 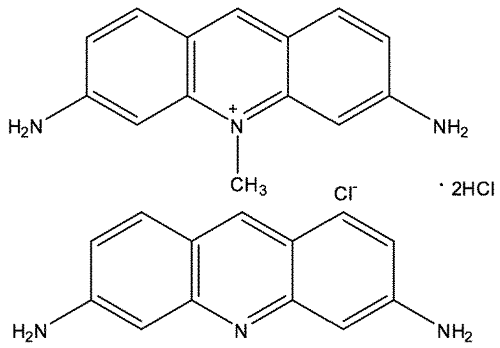 | 8063-24-9 |
| blau | 3,6-Diaminoacridine hydrichloride | 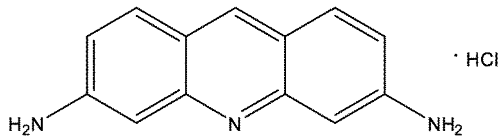 | 962-23-8 |

## UV-Initiatoren

### Flüssige UV-Initiatoren

Die Farbstoffe sind pulverförmig. Damit sie der Mischung zugegeben werden können, müssen sie gelöst werden. Es zeigte sich, dass sie sich gut in flüssigen UV-Fotoinitiatoren lösen lassen. Dies ist vorteilhaft, da nach der Laserbelichtung für die letztendliche UV-Härtung sowieso UV-Initiatoren benötigt werden.

Beispiele

| **Markenname** | CAS | **Molekül** |
|---|---|---|
| Omnirad MBF (IGM) | 15206-55-0 | 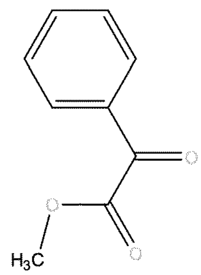 |
| Omnirad 1173 oder auch Omnirad 73 genannt (IGM) | 7473-98-5 | 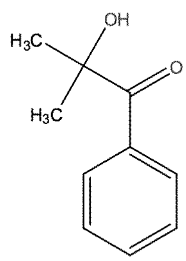 |

(fortgesetzt)

| **Markenname** | CAS | **Molekül** |
|---|---|---|
| Omnirad 1000 (IGM) | 7473-98-5 + 947-19-3 | 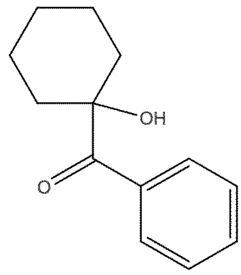 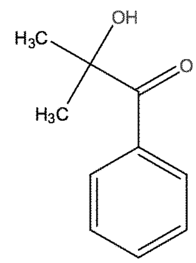 |
| Omnirad TPO-L (IGM) | 84434-11-7 | 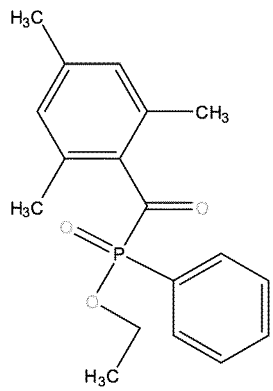 |

**Pulverförmige UV-Initiatoren**

Auch bei Raumtemperatur pulverförmige UV-Initiatoren können verwendet werden, wenn sie geschmolzen werden oder in einer zweiten Komponente gelöst werden.

Beispiele

| **Markenname** | CAS | **Molekül** |
|---|---|---|
| Omnirad 184 (IGM) | 947-19-3 | 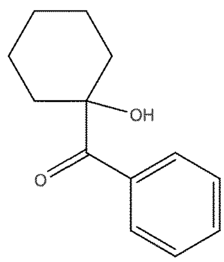 |

(fortgesetzt)

| Markenname | CAS | Molekül |
|---|---|---|
| Omnirad 819 (IGM) | 162881-26-7 | 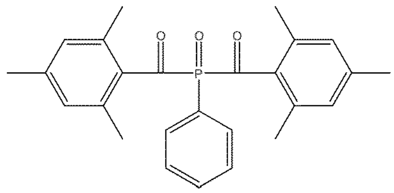 |
| Omnirad TPO (IGM) | 75980-60-8 | 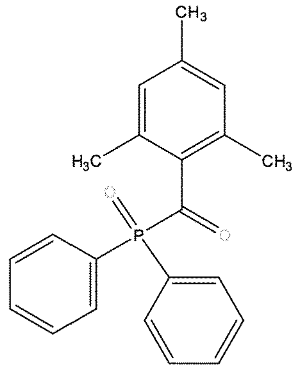 |
| OXE-01 (BASF) | 253585-83-0 | 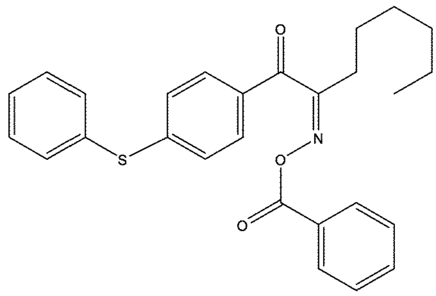 |

## Lösungsmittel

### Flüchtige

Beispiele

| Bezeichnung | Molekül | CAS | Molare Masse | Dampfdruck | Siedepunkt |
|---|---|---|---|---|---|
| Ethanol | 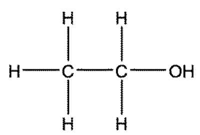 | 37625-56-2 | 46g/mol | 58hPa bei 20°C | 78°C |

### Hochsiedende

Beispiele

| **Bezeichnung** | **Molekül** | CAS | **Molare Masse** | **Dampfdruck** | **Siedepunkt** |
|---|---|---|---|---|---|
| Dimethylsulfoxid, DMSO | 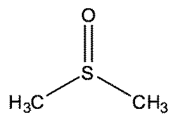 | 67-68-5 | 78g/mol | 0,42hPa bei 20°C | 189°C |
| N,N'-Dimethylpropylenharnstoff | 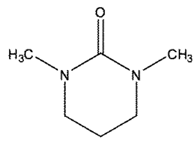 | 7226-23-5 | 128g/mol | 0,02hPa bei 20°C | 247°C |
| N-Methyl-2-pyrrolidon (NMP) | 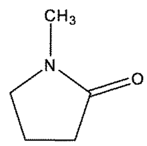 | 872-50-4 | 99g/mol | 0,32hPa bei 20°C | 204°C |
| Benzaldehyd | 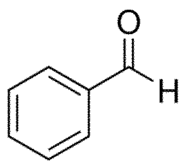 | 100-52-7 | 106g/mol | 1,26hPa bei 20°C | 179°C |
| N-Hydroxyethylacrylamid (H EAA) | 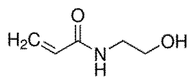 | 7646-67-5 | 115g/mol | | 130°C |

**Hochmolekulare**

Beispiele

| **Bezeichnung** | **Molekül** | CAS | **Molare Masse** |
|---|---|---|---|
| PolyCLO TMP540, Polycaprolactone, Capromer PT1-05 (BASF) | 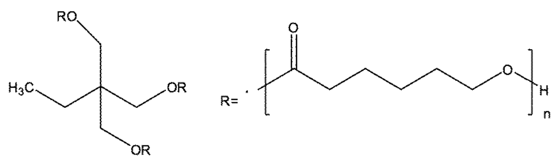 | 37625-56-2 | 540g/mol |
| Polycaprolactone triol, PCL-triol (Sigma-Aldrich) | 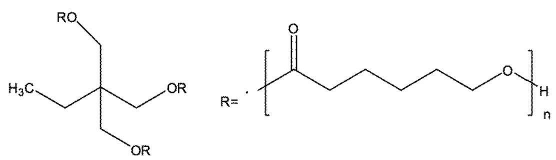 | 37625-56-2 | 300g/mol |
| Poly(BI-SPHENOL A-CO-EPICHLO-ROHyDRIN) | 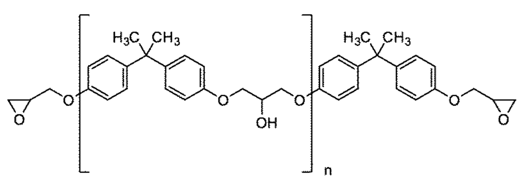 | 25036-25-3 | 377g/mol |

(fortgesetzt)

| **Bezeichnung** | **Molekül** | CAS | **Molare Masse** |
|---|---|---|---|
| Polyethylenglykol, PEG 200 | 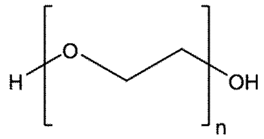 | 25322-68-3 | 200g/mol |
| Efka® PX 4701 (BASF) | acrylic block copolymer | | |

**Farbstoffkonzentrate**

Bevorzugt wird zur Auflösung der Farbstoffe ein Gemisch von Polycaprolacton und einem flüssigen UV-Photoinitiator (z.B. Omnicure 1173 oder MBF) verwendet. Anstatt eines flüssigen UV-Photoinitiator kann auch ein bei Raumtemperatur fester UV-Initiatior wie Omnicure TPO, Omnicure 819 und Omnicure 189 im niedermolekularen Polycaprolacton gelöst werden. Das Verhältnis wird so gewählt, dass der UV-Initiator und der Farbstoff später mit der gewünschten Konzentration in der photopolymerisierbaren Zusammensetzung aus dem Kit-of-parts vorliegen.

**Beispiel**

| **Menge** | **Zutat** |
|---|---|
| 2g | PCL-triol (Polycaprolactone triol), Mn 300g/mol |
| 1g | Omnirad 1173 |
| 0,1g | Diethylsafranin |

Wenn diese Menge von insgesamt 3,1 g zu 96,9 g einer monomerhaltigen flüssigen Mischung zugegeben wird, dann liegt die UV-Initiator-Konzentration in der dabei entstandenen photopolymerisierbaren Zusammensetzung aus dem Kit-of-parts bei 1%. Wenn eine andere Konzentration erwünscht wäre, dann müsste das Verhältnis vom PCL-triol und UV-Initiator entsprechend angepasst werden. Maximal wäre bei diesem Beispiel eine Photoinitiatorkonzentration von 3% möglich.

**Weitere Inhaltsstoffe**

Je nach verwendeten Farbstoff und UV-Initiator kann es nützlich sein weitere Coinitiatoren wie N-Phenylglycine(NPG), ein Amin-Synergist wie PHOTOCRYL A101 von Miwon oder ein Monomer wie N-Hydroxyethylacrylamid hinzuzufügen.

<u>**Farbstoffkonzentrate FK1 bis FK5 (Kit-of-parts I)**</u>

Die Farbstoffkonzentrate FK1 bis FK5 wurden analog dem Farbstoffkonzentrat 1 hergestellt. Die Komponenten werden nacheinander in ein Becherglas mit einem Rührmagneten gegeben. Das Becherglas steht dazu auf einer Waage, so dass die flüssigen Stoffe in der richtigen Menge hinzugegeben werden können. Danach wird alles auf einen beheizbaren Rührtisch auf 120°C erwärmt und verrührt. Die pulverförmigen Stoffe werden mit Hilfe von Wiegeschalen dosiert und unter Rühren der Mischung zugegeben. Die Mischung wird etwa 1h lang bei 120°C gerührt, bevor die Lösung gefiltert und in einer Flasche abgefüllt wird.

**Farbstoffkonzentrate FK1**

| Menge[g] | Menge[%] | Bezeichnung |
|---|---|---|
| 19,55 | 65,17% | PolyCLO TMP540 |
| 10,00 | 33,33% | Omnirad 1173 |
| 0,15 | 0,50% | NPG |
| 0,30 | 1,00% | Methylenblau |
| | | |
| 30,00 | 100,00% | |

**Farbstoffkonzentrate FK2**

| Menge[g] | Menge[%] | Bezeichnung |
|---|---|---|
| 8,10 | 27,00% | PolyCLO TMP540 |
| 20,00 | 66,67% | Omnirad 1173 |
| 1,00 | 3,33% | DMSO |
| 0,30 | 1,00% | NPG |
| 0,60 | 2,00% | Methylenblau |
| | | |
| 30,00 | 100,00% | |

**Farbstoffkonzentrate FK3**

| Menge[g] | Menge[%] | Bezeichnung |
|---|---|---|
| 0,97 | 4,85% | EFKA PX 4701 |
| 1,94 | 9,70% | N-Hydroxyethylacrylam id |
| 16,45 | 82,25% | PEG-200 |
| 0,64 | 3,20% | Methylenblau |
| | | |
| 20,00 | 100,00% | |

**Farbstoffkonzentrate FK4**

| Menge[g] | Menge[%] | Bezeichnung |
|---|---|---|
| 4,80 | 96,00% | Ethanol |
| 0,20 | 4,00% | Methylenblau |
| | | |
| 5,00 | 100,00% | |

**Farbstoffkonzentrate FK5**

| Menge[g] | Menge[%] | Bezeichnung |
|---|---|---|
| 12,00 | 40,00% | PCL-triol (Polycaprolactone triol), 300g/mol |
| 12,00 | 40,00% | Omnirad 1173 |
| 5,40 | 18,00% | Benzaldehyd |
| 0,60 | 2,00% | Methylenblau |
| | | |
| 30,00 | 100,00% | |

**Flüssige Zusammensetzung (Kit-of-parts II)**

Die flüssigen Zusammensetzungen MM1 bis MM4 wurden mit der gleichen Vorgehensweise hergestellt, wie sie bei den Farbstoffkonzentraten beschrieben wurde.

Flüssige Zusammensetzung MM1

| Menge[g] | Menge[%] | Bezeichnung |
|---|---|---|
| 35 | 79,46% | SR 349 |
| 7 | 15,89% | Rizinusöl |
| 0,2 | 0,45% | SEC LCA 1460 |
| 0,4 | 0,91% | Irgacure OXE01 |
| 0,25 | 0,57% | 2,4 Dihydroxybenzaldehyd |
| 1,2 | 2,72% | Hedipin R/2000 |
| | | |
| 44,05 | 100,00% | |

**Flüssige Zusammensetzung MM2**

| Menge[g] | Menge[%] | Bezeichnung |
|---|---|---|
| 31,78 | 63,56% | SR 349 |
| 6,36 | 12,72% | Rizinusöl |
| 0,18 | 0,36% | SEC LCA 1460 |
| 0,36 | 0,72% | Irgacure OXE01 |
| 0,23 | 0,46% | 2,4 Dihydroxybenzaldehyd |
| 1,09 | 2,18% | Hedipin R/2000 |
| 7,00 | 14,00% | EPI |
| 3,00 | 6,00% | PEG-PP-PEG |
| | | |

(fortgesetzt)

| Menge[g] | Menge[%] | Bezeichnung |
|---|---|---|
| 50,00 | 100,00% | |

**Flüssige Zusammensetzung MM3**

| Menge[g] | Menge[%] | Bezeichnung |
|---|---|---|
| 287,5 | 57,16% | SR 349 |
| 212,5 | 42,25% | Ebecryl 230 |
| 3 | 0,60% | SEC LCA 1460 |
| | | |
| 503,00 | 100,00% | |

**Flüssige Zusammensetzung MM4**

| Menge[g] | Menge[%] | Bezeichnung |
|---|---|---|
| 23 | 57,07% | SR 349 |
| 17 | 42,185% | CN 9002 |
| 0,3 | 0,74% | SEC LCA 1460 |
| | | |
| 40,30 | 100,00% | |

**Kit-of-parts**

Aus den vorher beschriebenen Farbstoffkonzentraten und den monomerhaltigen flüssigen Zusammensetzungen, die zusammen ein entsprechendes Kit-of-parts bilden, entsteht durch Vermischen (beispielsweise durch Schütteln mit einem Speedmixer oder Verrühren mit einem Rührstäbchen) eine photopolymerisierbare Zusammensetzung. Folgende photopolymerisierbare Zusammensetzungen werden beschrieben:

**Photopolymerisierbare Zusammensetzung A**

| Menge[g] | Menge[%] | Komponente | Name |
|---|---|---|---|
| 5 | 97,09% | MM2 | Flüssige Zusammensetzung |
| 0,15 | 1,91% | FK1 | Farbstoffkonzentrat |
| | | | |
| 5,15 | 100,00% | | |

**Photopolymerisierbare Zusammensetzung B**

| Menge[g] | Menge[%] | Komponente | Name |
|---|---|---|---|
| 5 | 97,09% | MM3 | Flüssige Zusammensetzung |
| 0,15 | 1,91% | FK1 | Farbstoffkonzentrat |
| | | | |
| 5,15 | 100,00% | | |

**Photopolymerisierbare Zusammensetzung C**

| Menge[g] | Menge[%] | Komponente | Name |
|---|---|---|---|
| 5 | 98,62% | MM2 | Flüssige Zusammensetzung |
| 0,07 | 1,38% | FK2 | Farbstoffkonzentrat |
| | | | |
| 5,07 | 100,00% | | |

**Photopolymerisierbare Zusammensetzung D**

| Menge[g] | Menge[%] | Komponente | Name |
|---|---|---|---|
| 5 | 98,62% | MM3 | Flüssige Zusammensetzung |
| 0,07 | 1,38% | FK2 | Farbstoffkonzentrat |
| | | | |
| 5,07 | 100,00% | | |

**Photopolymerisierbare Zusammensetzung E**

| Menge[g] | Menge[%] | Komponente | Name |
|---|---|---|---|
| 5 | 97,09% | MM2 | Flüssige Zusammensetzung |
| 0,15 | 2,91% | FK3 | Farbstoffkonzentrat |
| | | | |
| 5,15 | 100,00% | | |

**Photopolymerisierbare Zusammensetzung F**

| Menge[g] | Menge[%] | Komponente | Name |
|---|---|---|---|
| 5 | 97,09% | MM2 | Flüssige Zusammensetzung |
| 0,15 | 2,91% | FK4 | Farbstoffkonzentrat |
| | | | |

(fortgesetzt)

| Menge[g] | Menge[%] | Komponente | Name |
|---|---|---|---|
| 5,15 | 100,00% | | |

**Photopolymerisierbare Zusammensetzung G**

| Menge[g] | Menge[%] | Komponente | Name |
|---|---|---|---|
| 5 | 97,09% | MM1 | Flüssige Zusammensetzung |
| 0,15 | 2,91% | FK1 | Farbstoffkonzentrat |
| | | | |
| 5,15 | 100,00% | | |

**Photopolymerisierbare Zusammensetzung H**

| Menge[g] | Menge[%] | Komponente | Name |
|---|---|---|---|
| 5 | 97,09% | MM4 | Flüssige Zusammensetzung |
| 0,15 | 2,91% | FK5 | Farbstoffkonzentrat |
| | | | |
| 5,15 | 100,00% | | |

**Belichtungen**

**Belichtungen**

| Material | Peak[nm] | BWG[%] | Dicke[μm] | nicht mehr belichtbar nach |
|---|---|---|---|---|
| A | 585 | 87 % | 65 | 0h 45m |
| B | 578 | 87 % | 138 | 1h 30m |
| C | 586 | 85 % | 69 | 0h 40m |
| D | 577 | 96 % | 126 | 1h 40m |
| E | 581 | 95 % | 18 | 0h 45m |
| F* | 578 | 90 % | 24 | 1h 8m |
| G | 577 | 92 % | 21 | 2h 18m |
| H | 578 | 96 % | 115 | 4h 45m |
| * Referenzbeispiel | | | | |

Belichtet wurde mit einer Wellenlänge von 577 nm bei einer Temperatur von 20°C. Das Material wurde in einem Ofen bei 120°C aufbewahrt. Es wurde ca. alle 15 min eine Belichtung vorgenommen, solange bis kein Hologramm mehr einbelichtet werden konnte und der BWG-Wert entsprechend 0% betrug. Die angegebenen Werte stammen von der ersten Belichtung.

Die monomerhaltigen Mischungen bzw. die flüssige Zusammensetzung des Kit-of-parts II wurden mindestens

3 Monate bei Raumtemperatur gelagert. Vor der Verwendung wurden sie 4 Stunden lang bei 120°C im Ofen aufbewahrt, um die auskristallisierten Boratsalze wieder in Lösung zu bringen. Die Mischung MM2 stammte aus einer besonders alten Charge. Sie war über 5 Jahre alt und wurde zwischendurch häufig wieder auf 120°C erwärmt ohne an Qualität einzubüßen. Auch das Farbkonzentrat FK3 war mit über drei Jahren schon besonders alt. Solange die Farbkonzentrate lichtgeschützt aufbewahrt werden, können sie ebenso wie die monomerhaltigen flüssigen Zusammensetzungen als Kit-of-parts mindestens 1 Jahr lang bei Raumtemperatur gelagert werden.

Figur 1 zeigt ein Foto von zwei Anmischungen der flüssigen Zusammensetzung II). Im linken Becher (1) befindet sich eine flüssige Zusammensetzung II), die schon länger, über drei Monate bei Raumtemperatur gelagert wurde. Im rechten Becher (2) befindet sich eine flüssige Zusammensetzung II), die kurz vorher drei Stunden lang bei 120°C auf eine Heizplatte mit einem Magnetrührer (3) gerührt wurde. Deutlich ist zu sehen, dass diese Mischung (2) klarer als die unbehandelt Gelagerte (1) mit den Auskristallisationen (4) ist.

## Belichtungsaufbau

Der Laserstrahl mit einer gemessenen Leistung von 1,43W wurde mit einem Polygonscanner horizontal aufgeweitet und durch eine Zylinderlinse so gebündelt, dass er eine Belichtungsbreite von 23cm abdeckte. Figur 3 zeigt den schematischen Belichtungsaufbau.

Bezugszeichen in Figur 3:

1 Laser 577nm

2 Spiegel

3 Polygonscanner

4 Zylinderlinse

5 Scanstrahl

6 Scannerspiegel

Die jeweiligen Proben wurden mit Hilfe eines verschiebbaren Spiegels mit dieser Linie abgescannt und belichtet. Die Verfahrgeschwindigkeit wurde auf 9mm/s eingestellt. Der Laserstrahl fiel mit einem Winkel von 22° zum Lot auf die Probenoberfläche. Die Figur 4 zeigt den Strahlengang.

Bezugszeichen in Figur 4:

1 Scanstrahl 577nm

2 Scannerspiegel

3 Belichtungsrichtung

4 Belichtungswinkel, 22°

5 Substrat, Glas oder Folie

6 Photopolymer (photopolymerisierbare Zusammensetzung)

7 Master, Spiegelblech

Damit ein Reflexionshologramm entsteht wurde das Probenmaterial auf ein Spiegelblech aufgetragen, welches das Laserlicht zurückreflektiert. Durch die Interferenz des auftreffenden mit dem reflektierten Strahl entsteht parallel zur

Oberfläche des Spiegels ein Linienmuster aus hellen und dunklen Stellen. Dieses Interferenzmuster wird vom Material in Form einer Brechungsindexmodulation aufgezeichnet und es entsteht ein sogenanntes Lippmann-Bragg-Hologramm.

Bei der Laserbelichtung befindet sich die Photopolymerschicht zwischen den Spiegelblech und einem transparenten Trägermaterial, z.B. eine PET-Folie oder Glas.

Nach der Laserbelichtung wird das Material noch mit UV-Licht gehärtet. Für den ersten Härtungsschritt verwenden wir einen UV-Blitz mit einer Stärke von 3000 WS. Dies reicht aus um danach das Hologramm mit den Träger vom Blech zu entfernen. Damit die Haftung zum Glas gewährleistet ist, sollte dies mit einem Primer vorbehandelt werden.

Optional kann danach die Hologrammschicht unter einer üblichen UV-Lampe mit einer Quecksilberdampfbirne weiter gehärtet und gebleicht werden. Wir verwenden dazu eine UV-Brücke mit einer Lichtbogenlänge von 70 mm und einer Leistung von 120 W/cm. Die Proben B, D, und H wurden damit 30s bestrahlt, während die anderen Proben unbehandelt blieben und nach dem Blitzen gemessen wurden.

Figur 2 zeigt eine Vorrichtung zur Herstellung des aus dem beanspruchten Kit-of-parts hergestellten Hologramms.

## Messaufbau

Gemessen wurden die Proben mit einem Spektrometer (CAS 140 B von der Fa. Instrument Systems) in Durchlicht. Und zwar bei senkrechter Beleuchtung. Da das Hologramm nur die Wellenlänge reflektiert, welche die Bragg-Bedingung erfüllt, ist in der Spektralkurve an dieser Stelle ein deutlicher Absorptionspeak zu sehen.

Aus dem Peakwert $T_{Peak}$ und einem in der Nähe befindlichen Referenzwert $T_{Ref}$ auf der oberen Grundlinie berechnet sich der Beugungswirkungsgrad (BWG) $\eta$ wie folgt:

$$\eta = (T_{Ref} - T_{Peak})/T_{Ref}$$

Figur 5 zeigt die Messkurve mit den entsprechenden Meßpunkten der ersten Belichtung von der Probe H.

Die Tabellenwerte der Belichtungen zeigen, dass alle Beispielmischungen bei der ersten Belichtung einen hohen Beugungswirkungsgrad erzielen. Aber je länger das belichtbare Material bei einer hohen Temperatur aufbewahrt wird, desto schlechter werden die Ergebnisse bis nach einer gewissen Zeit überhaupt keine Hologramme mehr eingeschrieben werden können.

## Fertigung

Figur 2 zeigt den schematischen Aufbau einer kompakten Rolle zu Rolle Maschine für die Anfertigung von versiegelten holographischen Kontaktkopien aus den beanspruchten Kit-of-parts.

Bezugszeichen in Figur 2:

1 Vorratsbehälter für Komponente A
2 Vorratsbehälter für Komponente B
3 Mixer
4 Dosiereinheit
5 Photopolymer (photopolymerisierbare Zusammensetzung)
6 Trägerfolie
7 Trägerfolie mit Hologramm
8 Folienabwicklung
9 Folienaufwicklung
10 Master
11 Laserlicht
12 UV-Licht

## Patentansprüche

1. Kit-of-parts zur Herstellung einer photopolymerisierbaren Zusammensetzung mittels UV/Vis-Bestrahlung, umfassend:

I) ein Farbstoffkonzentrat, umfassend

A) eine erste Mischung A, umfassend

f) mindestens einen Farbstoff und
h) mindestens ein Lösungsmittel

und
II) eine flüssige Zusammensetzung umfassend:

B) eine monomerhaltige flüssige Mischung B, umfassend:

a) mindestens ein Monomer M1, umfassend mindestens eine ethylenisch ungesättigte Gruppe,
c) mindestens einen Co-Photoinitiator,

wobei über 80% aller Bestandteile des Lösungsmittels in dem Kit-of-parts oder in dem Farbstoffkonzentrat einen Dampfdruck von ≤ 2 hPa bei 20°C und einen Siedepunkt von ≥ 100°C bei Standarddruck aufweisen, und
wobei in dem Lösungsmittel ein unter Standarddruck flüssiges Polymer enthalten ist und wobei nach der Anmischung der photopolymerisierbaren Zusammensetzung diese sofort verarbeitbar und belichtbar ist.

**2.** Kit-of-parts zur Herstellung einer photopolymerisierbaren Zusammensetzung mittels UV/Vis-Bestrahlung gemäß Anspruch 1, wobei die erste Mischung A weiterhin umfasst:
g) mindestens einen Photoinitiator, wobei der Photoinitiator unter Bestrahlung mit einer Wellenlänge zwischen 100 nm und 480 nm Radikale bilden kann.

**3.** Kit-of-parts gemäß einem der Ansprüche 1 und 2, wobei der Photoinitiator flüssig ist und/oder ausgewählt ist aus der Gruppe, bestehend aus 1,2-Octandion-1-[4-(phenylthio)-phenyl]-2-(O-benzoyloxim), (1-[9-Ethyl-6-(2-methylbenzoyl)-9H-carbazol-3-yl]ethanon-O-acetyloxim, Methylbenzoylformiat), 2,4,6-Trimethylbenzoyl-diphenyl-phosphinoxid, Ethyl-(2,4,6-trimethylbenzoyl)-phenylp-hosphinat), 2-Hydroxy-2-methyl-1-phenylpropanon, einer Mischung aus 2-Hydroxy-2-methyl-1-phenylpropanon (80%) und 1- Hydroxycyclohexyl-phenylketon (20%), 1-Hydroxycyclohexyl-phenylketon, Bis(2,4,6-trimethylbenzoyl)phenylphosphinoxid, einer Mischung aus 2-Hydroxy-2-methyl-1-phenyl-propanon, Bis(2,4,6-trimethylbenzoyl)phenylphosphinoxid und Ethyl(2,4,6-trimethylbenzoyl)-phenylphosphinat), und 4,4'-Dimethyl-diphenyl-iodonium-hexafluorphosphat.

**4.** Kit-of-parts gemäß einem der Ansprüche 1 bis 3, wobei der Farbstoff ein Fluoreszenzfarbstoff ist.

**5.** Kit-of-parts gemäß einem der Ansprüche 1 bis 4, wobei der Farbstoff ausgewählt ist aus der Gruppe, bestehend aus Acriflavinen, Diaminoacridinen, Rhodamin B, Safranin-O, Diethylsafranin und Methylenblau.

**6.** Kit-of-parts gemäß einem der Ansprüche 1 bis 5, wobei der Co-Photoinitiator ausgewählt ist aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus.

**7.** Kit-of-parts gemäß einem der voranstehenden Ansprüche, wobei die monomerhaltige flüssige Mischung B bei einem Standarddruck im Bereich von 15°C bis 120°C flüssig ist.

**8.** Kit-of-parts gemäß einem der voranstehenden Ansprüche, wobei das unter Standarddruck flüssige Polymer ausgewählt ist aus der Gruppe, bestehend aus Polyethylenglykolen (PEGs), Polycaprolactonen, Acrylat-Block-Copolymeren (EFKA) und Poly(Bisphenol-A-co-epichlorhydrinen) (EPI).

**9.** Kit-of-parts gemäß einem der voranstehenden Ansprüche, umfassend

I) höchstens 10 Gew.-% einer ersten Mischung A, bezogen auf die Gesamtmenge der Mischung B.

**10.** Element, enthaltend eine Komponente, die erhältlich ist durch die Einwirkung von (aktinischer) UV/VIS-Strahlung auf die photopolymerisierbare Zusammensetzung aus dem Kit-of-parts nach einem der voranstehenden Ansprüche.

**11.** Element nach Anspruch 10, umfassend ein Hologramm, das erhältlich ist durch die Einwirkung einer holographischen Information tragenden, modulierten Strahlung auf die photopolymerisierbare Zusammensetzung aus dem Kit-of-parts nach einem der der voranstehenden Ansprüche.

**12.** Verwendung des Elements nach einem der Ansprüche 10 oder 11, als Folie, Linse, Gitter, Prisma, Spiegel, Strahlteiler, Diffusor, Oberflächenrelief, Membran, Filter oder Sensor.

**13.** Verwendung des Elements nach einem der Ansprüche 10 oder 11, für ein Head-up-Display, eine Datenbrille, ein Lichtleitsystem, ein Spektrometer, ein Detektionssystem, ein Sicherheitselement oder ein Label.

## Claims

**1.** Kit-of-parts for the preparation of a photopolymerisable composition by means of UV/Vis irradiation, comprising:

I) a dye concentrate comprising

A) a first mixture A comprising

(f) at least one dye; and
(h) at least one solvent

and
II) a liquid composition comprising:

B) a monomer-containing liquid mixture B comprising:

a) at least one monomer M1 comprising at least one ethylenically unsaturated group,
c) at least one co-photoinitiator,

wherein more than 80% of all components of the solvent in the kit-of-parts or in the dye concentrate have a vapour pressure of ≤ 2 hPa at 20°C and a boiling point of ≥ 100°C at standard pressure, and
wherein a polymer which is liquid under standard pressure is contained in the solvent and wherein, after mixing of the photopolymerisable composition, it is immediately processable and exposable.

**2.** A kit-of-parts for the preparation of a photopolymerisable composition by means of UV/Vis irradiation according to claim 1, wherein the first mixture A further comprises:
(g) at least one photoinitiator, wherein the photoinitiator can form radicals under irradiation with a wavelength between 100 nm and 480 nm.

**3.** A kit-of-parts according to any one of claims 1 and 2, wherein the photoinitiator is liquid and/or selected from the group consisting of 1,2-octanedione-1-[4-(phenylthio)-phenyl]-2-(O-benzoyloxime), (1-[9-ethyl-6-(2-methylbenzoyl)-9H-carbazol-3-yl]ethanone-O-acetyloxime, methylbenzoyl formate), 2,4,6-trimethylbenzoyl diphenyl phosphine oxide, ethyl (2,4,6-trimethylbenzoyl) phenyl phosphinate), 2-hydroxy-2-methyl-1-phenyl propanone, a mixture of 2-hydroxy-2-methyl-1-phenylpropanone (80%) and 1-hydroxycyclohexyl-phenylketone (20%), 1-hydroxycyclohexyl-phenylketone, bis(2,4,6-trimethylbenzoyl)phenylphosphine oxide, a mixture of 2-hydroxy-2-methyl-1-phenylpropanone, bis(2,4,6-trimethylbenzoyl)phenylphosphine oxide and ethyl(2,4,6-trimethylbenzoyl)phenylphosphinate), and 4,4'-dimethyl-diphenyl-iodonium hexafluorophosphate.

**4.** A kit-of-parts according to any one of claims 1 to 3, wherein the dye is a fluorescent dye.

**5.** A kit-of-parts according to any one of claims 1 to 4, wherein the dye is selected from the group consisting of acriflavins, diaminoacridins, rhodamine B, safranin-O, diethylsafranin and methylene blue.

**6.** A kit-of-parts according to any one of claims 1 to 5, wherein the co-photoinitiator is selected from the group consisting of tetrabutylammonium tetrahexyl-borate, tetrabutylammonium triphenylhexylborate, tetrabutylammonium tris-(3-fluorophenyl)-hexylborate and tetrabutylammonium tris-(3-chloro-4-methylphenyl)-hexylborate or mixtures thereof.

7. A kit-of-parts according to any one of the preceding claims, wherein the monomer-containing liquid mixture B is liquid at a standard pressure in the range from 15°C to 120°C.

8. A kit-of-parts according to any one of the preceding claims, wherein the polymer liquid under standard pressure is selected from the group consisting of polyethylene glycols (PEGs), polycaprolactones, acrylate block copolymers (EFKA) and poly(bisphenol A-co-epichlorohydrins) (EPI).

9. A kit-of-parts according to any one of the preceding claims, comprising

I) not more than 10 % by weight of a first mixture A, based on the total amount of mixture B.

10. Element comprising a component obtainable by the action of (actinic) UV/VIS radiation on the photopolymerisable composition from the kit-of-parts according to any one of the preceding claims.

11. An element according to claim 10, comprising a hologram obtainable by exposing the photopolymerisable composition from the kit-of-parts according to any one of the preceding claims to modulated radiation carrying holographic information.

12. Use of the element according to any one of claims 10 or 11, as a film, lens, grating, prism, mirror, beam splitter, diffuser, surface relief, membrane, filter or sensor.

13. Use of the element according to any one of claims 10 or 11, for a head-up display, data glasses, light guidance system, spectrometer, detection system, security element or label.

**Revendications**

1. Kit de pièces pour la production d'une composition photopolymérisable au moyen d'une irradiation UV/visible, comprenant :

I) un concentré de colorant, comprenant

A) un premier mélange A, comprenant
f) au moins un colorant et
h) au moins un solvant
et

II) une composition liquide comprenant :
B) un mélange B liquide contenant des monomères, comprenant :

a) au moins un monomère M1, comprenant au moins un groupe à insaturation éthylénique,
c) au moins un co-photoinitiateur,

plus de 80 % de tous les constituants du solvant dans le kit de pièces ou dans le concentré de colorant présentant une pression de vapeur $\leq$ 2 hPa à 20 °C et un point d'ébullition $\geq$ 100 °C à la pression normale, et
un polymère liquide à la pression normale étant contenu dans le solvant et, après le mélange de la composition photopolymérisable, celle-ci pouvant être immédiatement traitée et irradiée.

2. Kit de pièces pour la production d'une composition photopolymérisable au moyen d'une irradiation UV/visible selon la revendication 1, le premier mélange A comprenant en outre :
g) au moins un photoinitiateur,
le photoinitiateur pouvant former des radicaux sous irradiation avec une longueur d'onde située entre 100 nm et 480 nm.

3. Kit de pièces selon l'une des revendications 1 et 2, le photoinitiateur étant liquide et/ou étant choisi dans le groupe constitué de 1,2-octanedione-1-[4-(phénylthio)-phényl]-2-(O-benzoyloxime), (1-[9-éthyl-6-(2-méthylbenzoyl)-9H-carbazol-3-yl]éthanone-O-acétyloxime, formiate de méthylbenzoyle), oxyde de diphényl(2,4,6-triméthylbenzoyl)phosphine, éthyl phényl(2,4,6-triméthylbenzoyl)phosphinate), 2-hydroxy-2-méthyl-1-phénylpropanone, un mélange de 2-hydroxy-2-méthyl-1-phénylpropanone (80 %) et de 1-hydroxycyclohéxyl-phénylcétone (20 %), 1-hydroxycyclohéxyl-phénylcétone, oxyde de phényl(bis(2,4,6-triméthylbenzoyl))phosphine, un mélange de 2-hydroxy-2-méthyl-1-phénylpropanone, d'oxyde de phényl(bis(2,4,6-triméthylbenzoyl))phosphine et d'éthyl phényl(2,4,6-triméthylbenzoyl)phosphinate, et 4,4'-diméthyl-diphényl-iodonium-hexafluorophosphate.

**4.** Kit de pièces selon l'une des revendications 1 à 3, le colorant étant un colorant fluorescent.

**5.** Kit de pièces selon l'une des revendications 1 à 4, le colorant étant choisi dans le groupe constitué d'acriflavines, diaminoacridines, rhodamine B, safranine-O, diéthylsafranine et bleu de méthylène.

**6.** Kit de pièces selon l'une des revendications 1 à 5, le co-photoinitiateur étant choisi dans le groupe constitué de tétrahexylborate de tétrabutylammonium, triphénylhexylborate de tétrabutylammonium, tris-(3-fluorophényl)-hexylborate de tétrabutylammonium et tris-(3-chloro-4-méthylphényl)-hexylborate de tétrabutylammonium ou de mélanges de ceux-ci.

**7.** Kit de pièces selon l'une des revendications précédentes, le mélange B liquide contenant des monomères étant liquide à une pression normale dans la plage de 15 °C à 120 °C.

**8.** Kit de pièces selon l'une des revendications précédentes, le polymère liquide à une pression normale étant choisi dans le groupe constitué de polyéthylèneglycols (PEG), polycaprolactones, copolymères séquencés d'acrylate (EFKA) et poly(bisphénol-A-co-épichlorhydrines) (EPI).

**9.** Kit de pièces selon l'une des revendications précédentes, comprenant

I) au maximum 10 % en poids d'un premier mélange A, par rapport à la quantité totale du mélange B.

**10.** Élément contenant un composant qui peut être obtenu par l'action d'une irradiation UV/visible (actinique) sur la composition photopolymérisable provenant du kit de pièces selon l'une des revendications précédentes.

**11.** Élément selon la revendication 10, comprenant un hologramme, lequel peut être obtenu par l'action d'une irradiation modulée portant des informations holographiques sur la composition photopolymérisable provenant du kit de pièces selon l'une des revendications précédentes.

**12.** Utilisation de l'élément selon l'une des revendications 10 ou 11, en tant que feuille, lentille, grille, prisme, miroir, séparateur de faisceaux, diffuseur, relief de surface, membrane, filtre ou capteur.

**13.** Utilisation de l'élément selon l'une des revendications 10 ou 11 pour un affichage tête haute, des lunettes numériques, un système de guidage de lumière, un spectromètre, un système de détection, un élément de sécurité ou une étiquette.

**Figur 1:**

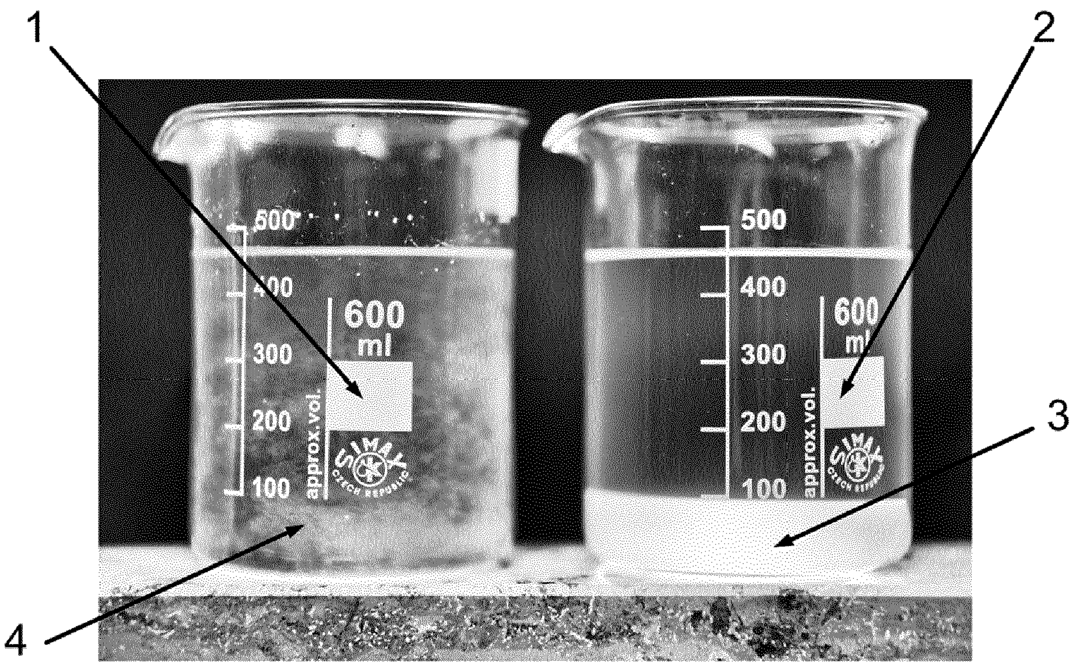
1
2
3
4
500
400
300
200
100
600
ml
approx.vol.
SIMAX
CZECH REPUBLIC

**Figur 2:**

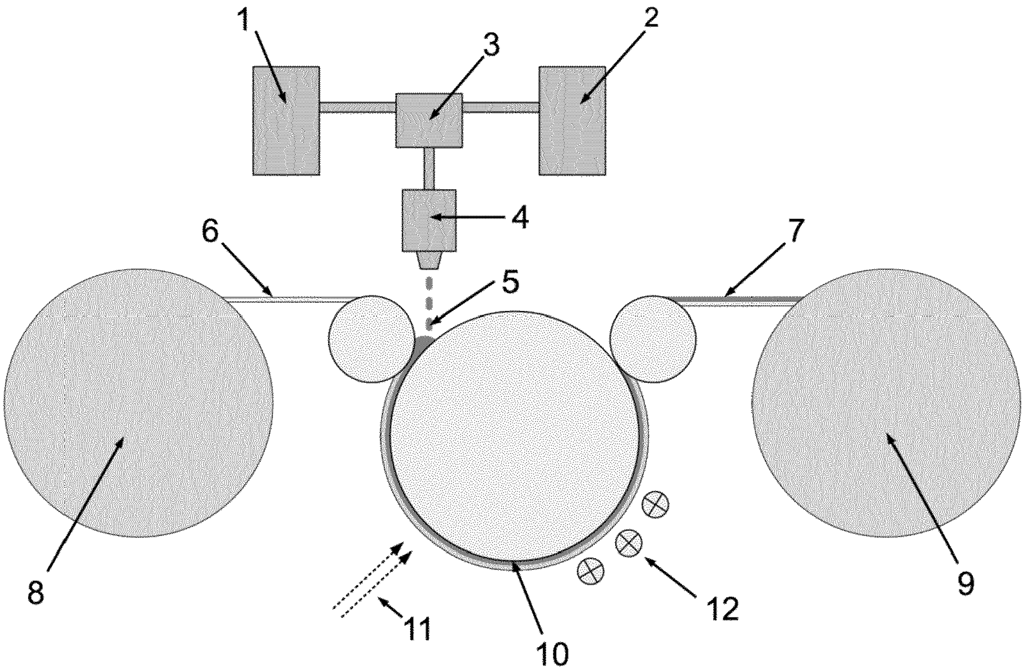

**Figur 3:**

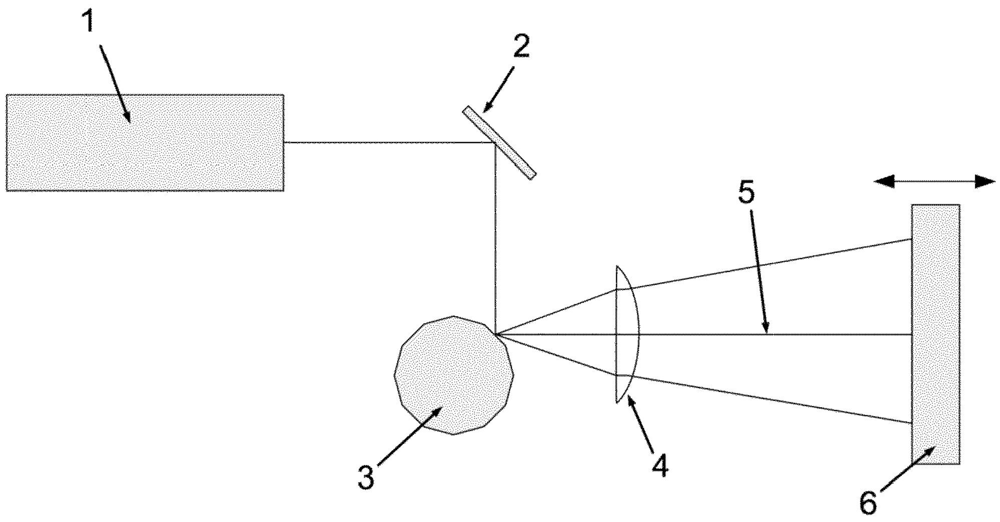

**Figur 4:**

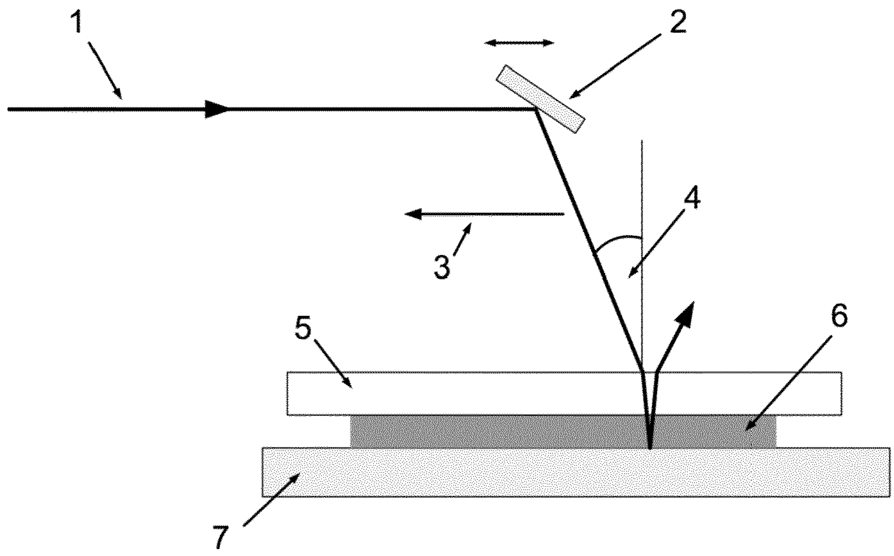

**Figur 5:**

Absorptionskurve der Probe H

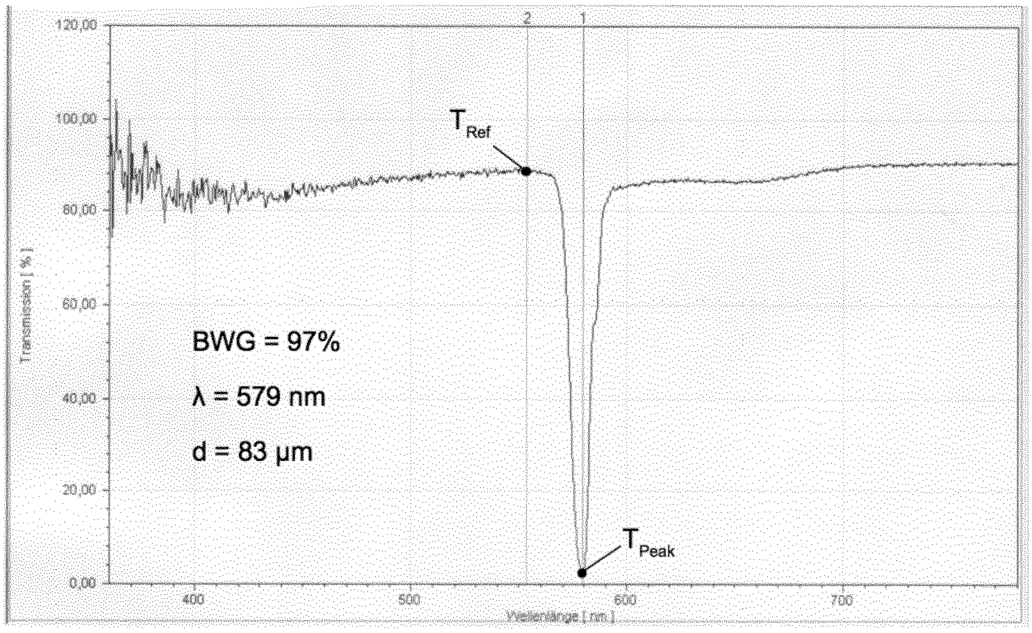

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 0324480 A2
- US 4942112 A
- DE 69032682 T2
- DE 68905610 T2
- US 5759721 A
- EP 1510862 A2
- US 200505891 A1
- EP 123151 A1
- EP 0211615 A2
- US 20050068594 A1
- WO 2010091795 A1
- WO 2003036389 A1
- US 2002142227 A1
- EP 3313827 B1
- US 3993485 A
- EP 2372454 A1
- EP 2219073 A1
- EP 1779196 B1
- US 3554753 A
- US 3563750 A
- US 3563751 A
- US 3647467 A
- US 3652275 A
- US 4162162 A
- US 4268667 A
- US 4454218 A
- US 4535052 A
- US 4565769 A
- WO 2012062655 A2
- US 2760663 A
- US 2850445 A
- US 2875047 A
- US 3097096 A
- US 3097097 A
- US 3145104 A
- US 3579339 A
- US 3427161 A
- US 3479185 A
- US 3549367 A
- US 4311783 A
- US 4622286 A
- US 3784557 A
- US 4341860 A
- US 3854950 A
- US 4168982 A
- US 3390996 A
- US 4326010 A
- DE 60216490 T2
- US 5017406 A
- DE 60030223 T2


### In der Beschreibung aufgeführte Nicht-Patentliteratur


- **HOWARD M. SMITH.** Principles of Holography. Wiley, 1969
- **FRED UNTERSEHER et al.** Holography Handbook: Making Holograms the Easy Way. Ross Books, 1982
- **GRAHAM SAXBY.** Practical Holography. Inst, of Physics Pub, 2004
- **S. M. SCHULTZ et al.** Volume grating preferential-order focusing waveguide coupler. *Opt. Lett.,* Dezember 1999, vol. 24, 1708-1710
- **B. VON NECKERS et al.** Poly. Chem. *J. Polym. Sci.,* 1995, vol. 33, 1691-1703
- **Z.B. TIMPE, H.J. ; S. NEUENFELD.** Dyes in photoinitiator systems. *Kontakte,* 1990, 28-35
- **JAKUBIAK, J. ; J.F. RABEK.** Photoinitiators for visible light polymisation. *Polimery,* 1999, vol. 44, 447-461
- Dye Sensitized Photopolymerization. **D.F: EATON.** Adv. in Photochemistry. Wiley-Interscience, 1986, vol. 13, 427-487
- *CHEMICAL ABSTRACTS,* 477-73-6
- *CHEMICAL ABSTRACTS,* 15206-55-0
- *CHEMICAL ABSTRACTS,* 947-19-3
- *CHEMICAL ABSTRACTS,* 37625-56-2
- *CHEMICAL ABSTRACTS,* 67-68-5